Europäisches Patentamt

European Patent Office

Office européen des brevets

(19)

(11) Publication number: **0 057 605**
**B1**

(12) **EUROPEAN PATENT SPECIFICATION**

(45) Date of publication of patent specification: **08.10.86**

(51) Int. Cl.⁴: **H 01 L 29/10,** H 01 L 29/80, H 01 L 21/265

(21) Application number: **82300499.9**

(22) Date of filing: **29.01.82**

(54) **A Schottky-barrier gate field effect transistor and a process for the production of the same.**

(30) Priority: **29.01.81 JP 11812/81**
**24.04.81 JP 62999/81**
**24.04.81 JP 63000/81**
**25.08.81 JP 133681/81**
**27.10.81 JP 172502/81**
**27.10.81 JP 172503/81**
**05.11.81 JP 178193/81**
**06.11.81 JP 178535/81**
**09.11.81 JP 180052/81**

(43) Date of publication of application:
**11.08.82 Bulletin 82/32**

(45) Publication of the grant of the patent:
**08.10.86 Bulletin 86/41**

(84) Designated Contracting States:
**DE FR GB NL**

(56) References cited:
**EP-A-0 005 461**
**DE-A-2 824 026**
**US-A-3 997 367**
**US-A-4 222 164**
**US-A-4 244 097**
**ELECTRICAL DESIGN NEWS, vol. 23, no. 17, 20
September 1978, Denver, USA, S. DAVIS "GaAs
Metal-semiconductor technology promises
gigahertz at low power", pages 44,46 to
48,51,52**

(73) Proprietor: **SUMITOMO ELECTRIC INDUSTRIES
LIMITED**
**No. 15, Kitahama 5-chome Higashi-ku
Osaka-shi Osaka 541 (JP)**

(72) Inventor: **Kikuchi, Kenichi**
**Osaka Works of Sumitomo Electric Industries
Ltd.**
**1-3 Shimaya, 1-chome Konohana-ku, Osaka (JP)**
Inventor: **Ebata, Toshiki**
**Osaka Works of Sumitomo Electric Industries
Ltd.**
**1-3 Shimaya, 1-chome Konohana-ku, Osaka (JP)**
Inventor: **Iiyama, Michitomo**
**Osaka Works of Sumitomo Electric Industries
Ltd.**
**1-3 Shimaya, 1-chome Konohana-ku, Osaka (JP)**
Inventor: **Hayashi, Hideki**
**Osaka Works of Sumitomo Electric Industries
Ltd.**
**1-3 Shimaya, 1-chome Konohana-ku, Osaka (JP)**

(74) Representative: **Cross, Rupert Edward Blount
et al**
**BOULT, WADE & TENNANT 27 Furnival Street
London EC4A 1PQ (GB)**

Courier Press, Leamington Spa, England.

**0 057 605**

(56) References cited:

IBM TECHNICAL DISCLOSURE BULLETIN, vol.
22, no. 7, December 1979, New York, NING et
al. "Self-Aligned Silicon MESFET or JFET",
pages 2918 to 2921

IBM TECHNICAL DISCLOSURE BULLETIN, vol.
21, no. 5, October 1978, New York, POGGE
"Reestablishing parallelism after RIE etching",
pages 1849 to 1850

## Description

This invention relates to a Schottky-barrier gate field effect transistor and a process for the production thereof.

Schottky-barrier gate field effect transistors (which will hereinafter be referred to as "MESFET") have widely been used as an element for providing amplification or oscillation, in particular with microwaves, and as well known in the art, are excellent as a basic element for an integrated circuit of ultra-high speed operation.

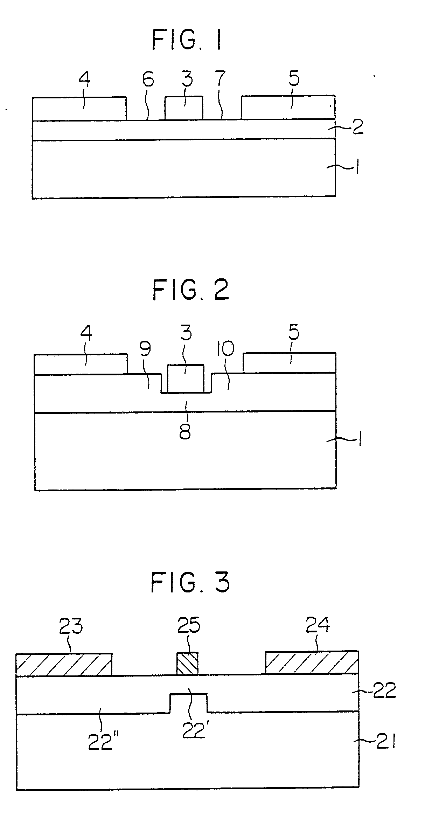

The structure of the most commonly used MESFET is as shown in Figure 1 of the accompanying drawings, in which 1 is a high resistance or semi-insulating semiconductor crystal substrate, 2 is an electrically conductive semiconductor crystal layer generally called an active layer, 3 is a Schottky-barrier gate electrode, and 4 and 5 are respectively a source electrode and drain electrode of ohmic character. The carrier concentration Nd and thickness $a$ of the active layer 2 have a relationship with the pinch-off voltage Vp of the MESFET, represented by the following equation (1):

$$Vp = Vb - \frac{qNd}{2\varepsilon} a^2 \qquad (1)$$

where Vb is a built-in voltage, $\varepsilon$ is a dielectric constant of the semiconductor, and q is an electronic charge.

Vp is given by the requirements of x circuit design, and Nd and $a$ are determined using the equation (1) so as to satisfy the value Vp.

One disadvantage of the prior art structure as shown in Figure 1 is that the transconductance gm obtained is not sufficiently large, and the noise characteristic is bad, because the resistance between gate 3 and source 4 or gate 3 and drain 5 is high. In particular, where the absolute value of the pinch-off voltage Vp is small, or in the case of "normally off" (Vp > 0), Nd- and a-values should be small, and thus the series resistance between the gate and source is larger as is evident from equation (1). When active layer 2 is of GaAs crystal, there is a high density surface state on crystal surface areas 6 and 7 between the gate and source and between the gate and drain, whereby the surface potential is substantially fixed, and a depletion layer is formed near the surface of the semiconductor crystal, resulting in a larger series resistance between the gate and source. This is a very important problem.

As a method of solving this problem, it has hitherto been proposed to make the active layer parts 9 and 10 between the gate and source, and between the gate and drain thicker than the active layer part 8 directly under the gate, as shown in Figure 2 of the accompanying drawings. According to this method, however, it is necessary to determine the thickness of the active layer part 8 and the carrier concentration so as to satisfy the condition of equation (1), but it is difficult to control precisely and reproducibly the thickness of the part 8 in such a structure by known manufacturing methods such as etching and the like. This known structure is obtained by forming a uniform thickness active layer having a thickness desired for the portion directly under source electrode 4 and drain electrode 5, and then making part 8 under gate electrode 3 thinner by etching before forming electrodes 4, 5 and 3. However, this known structure has the disadvantage that not only is forming of the electrodes difficult, but also high precision is required for control of the etching of the active layer, thus resulting in a low yield, both because the surface of the active layer is not flat.

In "Electrical Design News", Vol. 23, No. 17, of 20th September 1978, pages 44 to 52 in an article by S. Davis entitled "GaAs Metal-Semiconductor Technology Promises Gigahertz at Low Power", there is disclosed a Schottky-barrier gate field effect transistor comprising a semi-insulating semiconductor substrate, an active layer formed on the surface of the semiconductor substrate, and a source electrode, Schottky-barrier gate electrode and drain electrode formed on the active layer, the active layer having a first part formed near the gate electrode and a second part of the same conductivity type as the first part, and having a larger thickness than the first part formed between the gate electrode and the source electrode, the upper surfaces of the first part and second part of the active layer being in the same plane.

This known structure has the advantage of a flat upper surface for the active layer, but does nothing to improve the breakdown voltage and capacitance properties of the gate.

According to this invention a Schottky-barrier gate field effect transistor as set out above is characterised in that the second part of the active layer has a substantially similar carrier concentration to that of the first part.

Also according to this invention there is provided a process for the production of a Schottky-barrier gate field effect transistor, which comprises forming on a semi-insulating semiconductor substrate an active layer having a first part of one electrically conductive type semiconductor crystal with a thickness and carrier concentration chosen so as to give a predetermined pinch-off voltage, forming a stripe-like resist pattern on the active layer, introducing an impurity for giving the same conductivity type as the active layer through the active layer by ion implantation or thermal diffusion selectively through the pattern as a mask to form a second deeper part for the active layer on both sides of the first part thereof, removing the pattern and then forming a source electrode, drain electrode and gate electrode on the resulting level active layer, characterized in that the impurity is introduced to give a substantially similar carrier concentration in the second part of the active layer as in the first part thereof.

There is also provided a process for the production of a Schottky barrier gate field effect transistor, comprising forming on a semiconductor substrate an active layer with a uniform thickness and a planar outer surface, the active layer being of only one conductivity type and having a substantially uniform carrier concentration; forming a source electrode and a drain electrode on the surface of the active layer; forming a masking layer over the surface of the active layer and the source and drain electrodes, the masking layer having a window therein between the source and drain electrodes; implanting an inactivating ion through the window so as to form an insulating inactivated zone in the active layer and at the bottom thereof under the window while leaving the part of the active layer between the inactivated zone and the window substantially unaffected; depositing a metal to form a gate electrode through the window onto the active layer and onto the masking layer; and removing the masking layer and the metal layer thereon to expose the source and drain electrodes and leave the gate electrode on the thinner active part of the active layer above the inactivated zone.

This invention will now be described by way of example with reference to the accompanying drawings, in which:—

Figure 1 and Figure 2 are cross sectional views of prior art transistors as hereinbefore described;

Figure 3 is a cross sectional view of a first embodiment of field effect transistor according to the present invention;

Figures 4(A), (B) and (C) are cross sectional views illustrating in order steps in making the transistor shown in Figure 3;

Figure 5 is a graph showing carrier concentration distribution in the active layer of the transistor shown in Figure 3;

Figure 6 is a cross sectional view of a modified form of the first embodiment of field effect transistor according to the present invention shown in Figure 3;

Figure 7 is a cross-sectional view of a second embodiment of field effect transistor according to the present invention;

Figures 8(A), (B), (C), (D) and (E) are cross sectional views illustrating in order steps in making the transistor shown in Figure 7;

Figure 9 is a graph showing carrier concentration distribution in the active layer of the transistor shown in Figure 7;

Figure 10 is a cross sectional view of a third embodiment of field effect transistor according to the present invention;

Figures 11(A), (B), (C), (D), (E) and (F) are cross sectional views illustrating in order steps in making the transistor shown in Figure 10;

Figure 12 is a cross sectional view of a fourth embodiment of field effect transistor according to the present invention;

Figures 13(A), (B), (C), (D), (E), (F) and (G) are cross sectional views illustrating in order steps in making the transistor shown in Figure 12;

Figure 14 is a cross sectional view of a fifth embodiment of field effect transistor according to the present invention;

Figures 15(A), (B), (C), (D), (E) and (F) are cross sectional views illustrating in order steps in making the transistor shown in Figure 14;

Figure 16 is a graph showing the relationship between dose of oxygen and sheet resistivity;

Figure 17 is a cross sectional view of a sixth embodiment of field effect transistor according to the present invention;

Figures 18(A), (B), (C) and (D) are cross sectional views illustrating in order steps in making the field effect transistor shown in Figure 17;

Figures 19(A) and (B) are cross sectional views of two forms of a seventh embodiment of field effect transistor according to the present invention;

Figures 20(A), (B), (C) and (D) are cross sectional views illustrating in order steps in making the transistor shown in Figure 19(A);

Figures 21(A), (B) and (C) are cross sectional views illustrating in order steps in making the field effect transistor shown in Figure 19(B);

Figure 22 is a cross sectional view of an eighth embodiment of field effect transistor according to the present invention;

Figures 23(A), (B), (C) and (D) are cross sectional views illustrating in order steps in making the transistor shown in Figure 22;

Figure 24 is a cross sectional view of a ninth embodiment of field effect transistor according to the present invention; and

Figures 25(A), (B), (C) and (D) are cross sectional views illustrating in order steps in making the transistor shown in Figure 24.

Figures 1 and 2 of the drawings have been described above and will not therefore be described again.

Figure 3 is a cross sectional view of a first embodiment of Schottky-barrier gate field effect transistor according to the present invention, which comprises a semi-insulating semiconductor substrate 21 such as GaAs, an n-type active layer 22, source electrode 23, a drain electrode 24 and a Schottky-barrier gate electrode 25. In the field effect transistor shown in Figure 3 a part 22'' (second part) of active layer 22 having a larger thickness than another part 22' (first part) of active layer 22 directly under the gate electrode 25, is formed near source electrode 23 and drain electrode 24 while keeping flat the upper surface of active layer 22. Since the upper surface of active layer 22 is flat, fine photolithography is easy and the yield is thus increased in the formation of electrodes 23, 24 and 25 or in the production of integrated circuits, for example, monolithic microwave ICs such as microwave receiver heads with a mixer diodes, and high speed digital ICs.

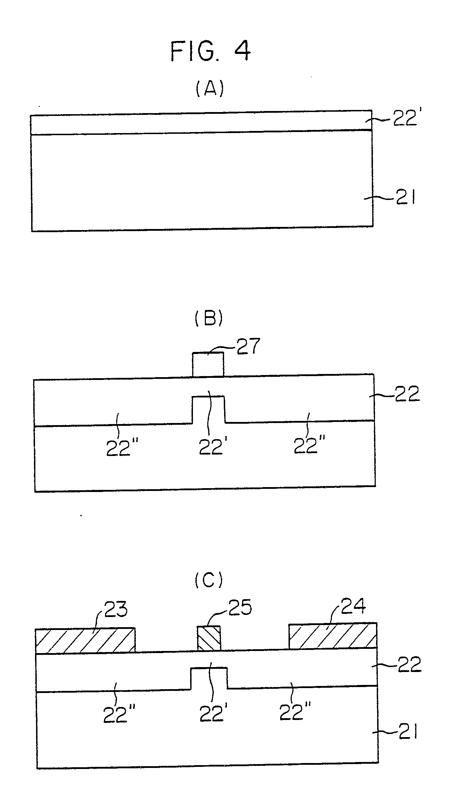

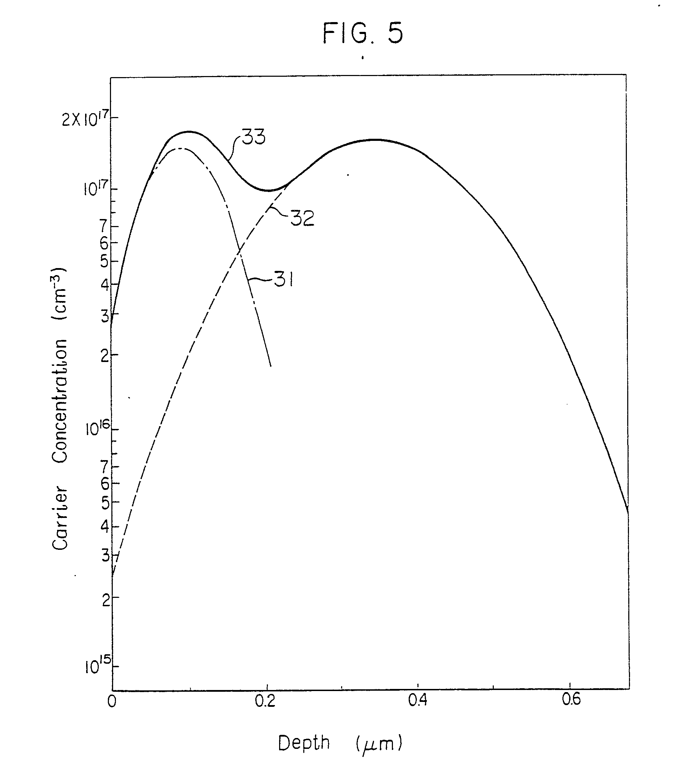

Figure 4(A), (B) and (C) are cross sectional views to illustrate a method of making the field effect transistor shown in Figure 3. Referring to Figure 4(A), $^{28}Si^+$ ion is implanted in the surface of a semi-insulating substrate 21 of GaAs to form active layer 22' with a uniform thickness. The thickness and carrier concentration of this active layer are so chosen as to realize a desired pinch-off voltage of preferably +0.3 to −3 V. For example, for obtaining a pinch-off voltage of $-2.2$ V it is necessary to form an active layer with a carrier concentration of $10^{17}$ cm$^{-3}$ and a thickness of 0.1 μm approximately, and implantation therefor is carried out, for example, with an implantation energy of 120 KeV and an implantation quantity of $2 \times 10^{12}$ ions/cm$^2$ where the doping efficiency is regarded as 100%. The theoretical value of the carrier concentration distribution obtained under these conditions is shown by chain line 31 in Figure 5.

As exemplified in Figure 4(B), after active layer 22' with a uniform thickness is formed, pattern 27 of photoresist is formed thereon. Using this pattern 27 as a mask, the second ion implantation is carried out to form a new active layer 22'' on the non-masked areas. The conditions for the second ion implantation are so chosen that the implantation energy is larger than that of the first implantation to implant more deeply and the implantation quantity is determined in such a range that the final peak carrier concentration is not too large to prevent a dielectric breakdown by a voltage applied to the gate and an increase of gate capacitance. When an implantation energy of 400 KeV and an implantation quantity of $3.9 \times 10^{12}$ ions/cm$^2$ are chosen as such implantation conditions, for example, the theoretical value of the carrier concentration distribution is shown by broken line 32 in Figure 5. The concentration of non-masked part 22'' in active layer 22 corresponds to the sum of the concentration by the first ion implantation plus that by the second ion implantation, which distribution is shown by solid line 33 in Figure 5.

Referring to Figure 4(C), the method is completed by removing mask 27, electrically activating the implanted ions by annealing, and then forming source electrode 23, drain electrode 24 and gate electrode 25 on predetermined sites on the flat active layer 22 by the use of a mask.

As can be seen from Figure 5, the total number of carriers in active layer 22'' near source electrode 23 is about three times more than that in active layer 22' directly under gate electrode 25 and, consequently, the resistance between the gate and source is decreased to 1/3 or less as compared with the case where active layer 22' is uniformly formed. On the other hand, since the peak carrier concentration in active layer 22'' becomes only about 13% more than that in active layer 22', decrease of the breakdown voltage of the gate and increase of the capacitance of the gate are held small.

An example of making the field effect transistor having the structure shown in Figure 3 by an ion implantation method has been described above; however the transistor can otherwise be produced by a thermal diffusion method. A shallow diffusion layer corresponding to active layer 22' of Figure 4(A) is firstly formed by contacting a dopant with a small diffusion constant with the surface of a substrate, followed by thermal diffusion. A mixed diffusion layer consisting of a shallow diffusion layer and a deep diffusion layer corresponding to active layer 22'' of Figure 4(B) is then formed by contacting another dopant with a large diffusion constant with the site not directly under the gate using a mask, followed by thermal diffusion, and finally, electrodes 23, 24 and 25 are formed. Alternatively, the structure of Figure 3 can be realized by depositing a dopant with a small diffusion constant on a gate part while depositing another dopant with a large diffusion constant on the part between the gate and source, and then subjecting both parts to thermal diffusion simultaneously.

The shorter the length of active layer 22' in Figure 3, the larger is the value of gm. This is a favourable characteristic. However, shortening of this length is limited by the fine photolithography used for electrode formation.

The relationship between the length of active layer 22' and that of gate electrode 25 will now be described.

In the case of a "normally on" type, which has a relatively thick active layer 22', even if the length of active layer 22' is somewhat longer than that of gate electrode 25, the properties are not significantly deteriorated because the problem does not arise that the part of active layer 22' not directly under the gate increases extremely the resistance between the gate and source, since active layer 22' is relatively thick and the thickness of the depletion layer from the upper surface does not extend to the whole thickness of active layer 22'.

On the contrary, in the case of a "normally off" type, in which the active layer 22' is relatively thin, if the length of the shallow active layer 22' is greater than that of gate electrode 25, the depletion layer in the region not directly beneath the gate will extend completely to the bottom of the shallow active layer, thus resulting in a marked increase of the resistance between the gate and source and in an extreme case, no current flow.

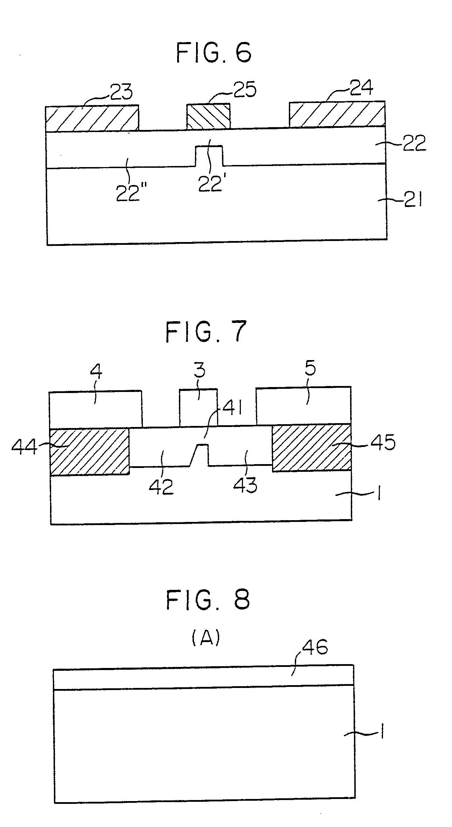

In order to solve such a problem, it is proposed for a "normally off" type to form the active layer 22' with a shorter length than that of a gate electrode 25 as shown in Figure 6 in which the reference numerals are as used in Figure 3.

A second embodiment of the present invention will now be described. With a decrease of the length of active layer 22', gm of the field effect transistor is increased, and a high gain and high speed operation are possible. An effective method of shortening the length of active layer 22' is given below.

Figure 7 shows a cross sectional view of the structure of such a field effect transistor according to the present invention having a low series resistance due to the presence of deep active layers 42 and 43 and thus excellent transconductance gm as well as high frequency properties. Since the effective gate length depends on the length of shallow active layer 41 and shortening of this length can readily be effected according to this embodiment, more excellent high frequency characteristics can be given.

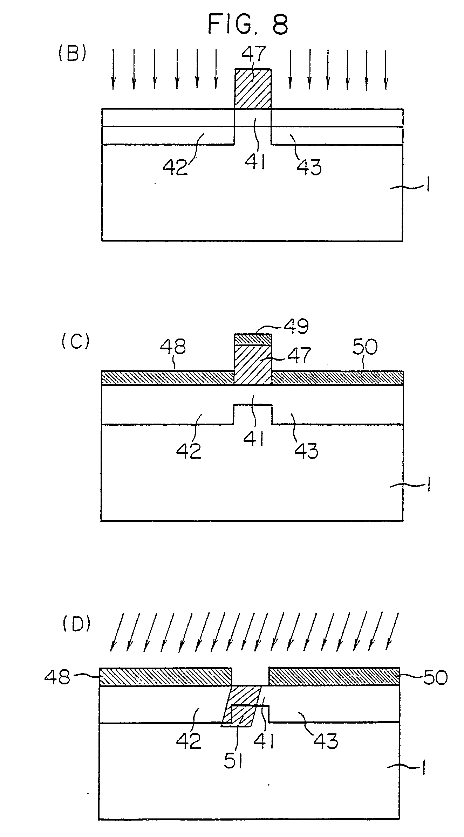

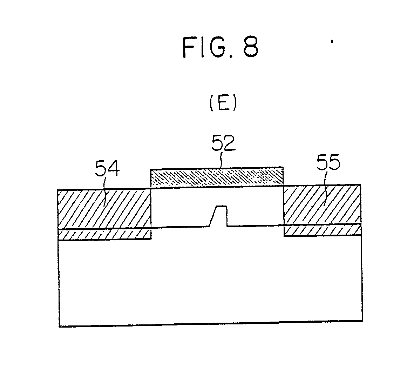

Figures 8(A), (B), (C), (D) and (E) are cross sectional views illustrating a process for making a MESFET as shown in Figure 7.

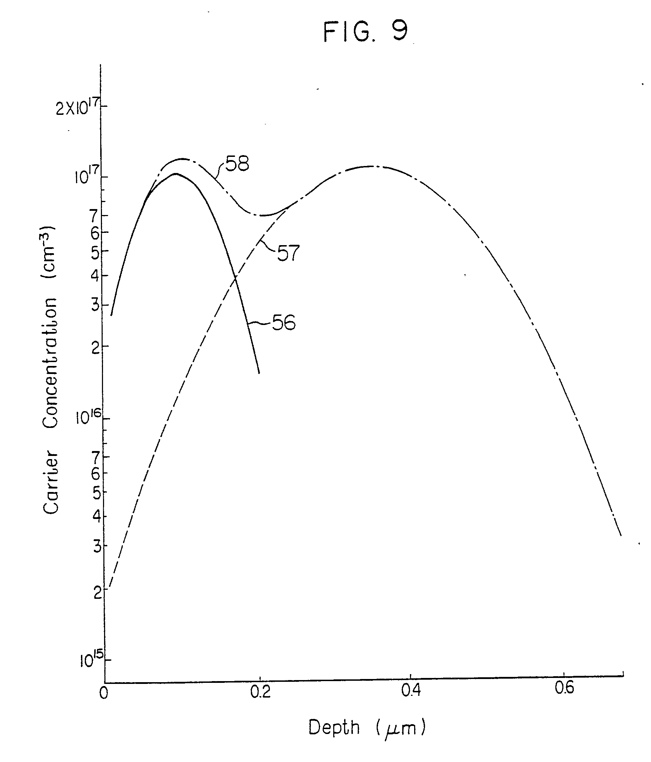

Referring to Figure 8(A), on the surface of a high resistivity or semi-insulating semiconductor crystal substrate 1 is formed a one electrical conductive type (n- or p-type) semiconductor crystal layer 46 with such a thickness and carrier concentration that a desired pinch-off voltage Vp, e.g. +0.3 to −3 V, is obtained according to equation (1). Preparation of semiconductor crystal layer 46 is generally carried out by the vapor phase epitaxial growth method, liquid phase epitaxial growth method or the method of implanting an impurity ion in the semi-insulating substrate 1. When $^{28}Si^+$ ion is implanted in a semi-insulating semiconductor substrate of GaAs to obtain an active layer (normally off) with a pinch-off voltage of 0 V, for example, the implantation is carried out with a $^{28}Si^+$ implantation quantity of $5.5 \times 10^{11}$ ions/cm$^2$ and an implantation energy of 120 KeV where the doping efficiency is regarded as 100%. The theoretical value of the carrier concentration distribution obtained under these conditions is shown by solid line 56 in Figure 9 in which the abscissa represents the distance, i.e. depth from the surface of the semiconductor crystal layer (μm) and the ordinate represents the carrier concentration (cm$^{-3}$).

A strip-like mask 47 is formed on the surface of the crystal layer 46 as shown in Figure 8(B). As the material of mask 47, photoresists and resists for electron beam lithography are suitable, but any other materials can also be used which are capable of being used as a selective mask for ion implantation, and being readily formed and stripped. An impurity capable of giving the same conductivity type as crystal layer 46 is introduced into the crystal substrate by the ion implantation method or thermal diffusion method using mask 47 to form deep active layers 42 and 43. When the thermal diffusion method is employed, a material having a sufficient heat resistance such as SiO$_2$, Si$_3$N$_4$ or the like should of course be used.

When the above described deep active layers are formed by ion implantation, the implantation energy is made larger than that used for the ion implantation of shallow active layer 41 so as to obtain a deeper implantation than in shallow active layer 41 and the implantation quantity is preferably chosen in such a range that the final peak carrier concentration is not too large to prevent a dielectric breakdown by a voltage applied to the gate and an excessive increase of gate capacitance. When an implantation energy of 400 KeV and an implantation quantity of $1.07 \times 10^{12}$ ions/cm$^2$ are chosen as such implantation conditions, for example, the theoretical value of the carrier concentration distribution is shown by broken line 57 in Figure 9. The concentration of non-masked parts 42 and 43 corresponds to the sum of the concentration by the first shallow ion implantation plus that by the second deep ion implantation, which distribution is shown by chain line 58 in Figure 9.

As can be seen from Figure 9, the total number of carriers in deep active layers 42 and 43 is about three times higher than that in the shallow active layer 41 for giving a pinch-off voltage and, consequently, the resistance between the gate and source can be decreased to 1/3 or less as compared with the prior art method wherein active layers 42 and 43 are formed in the same manner as active layer 41 as shown in Figure 1. If the second ion implantation is carried out with a larger dose, the gate-source resistance can further be decreased, but it is necessary to choose a suitable dose in order to prevent the carrier concentration being extremely large, the breakdown voltage of the gate is smaller than a desired value, and the gate capacitance is large.

Then, metallic films 48, 49 and 50 such as Al film are vapor-deposited onto the whole surface of the substrate as shown in Figure 8(C) and, thereafter, mask 47 is removed by the use of a suitable solvent, for example, organic solvents in the case of photoresists while vapor-deposited film 49 on mask 47 is simultaneously removed (lift off), thus obtaining vapor-deposited film patterns 48 and 50 as a reversal image of mask 47 as shown in Figure 8(D). Using metallic films 48 and 50 as a masking material, ion implantation is then carried out in a slant direction as shown in Figure 8(D) so that a part of window 51 has substantially the same carrier concentration distribution as deep active layers 42 and 43. In this case, it is important to effect the ion implantation in a slant direction so that a shallow part remains. This remaining shallow active layer 41 will later be used as a main active layer to give a pinch-off voltage. It will be understood that the length of the shallow main active layer 51 can be controlled easily and precisely by selecting suitably the implanting angle and the thickness of mask 50. For example, when the thickness of the mask is 500 nm (5000 Å) and the implanting angle is 30° from vertical, the length of main active layer 41 becomes about 290 nm (2900 Å). Practically, the length of active layer 41 is further shorter than the above described value because the implanted atoms are scattered laterally too.

In the prior art lithography, it is difficult to make an MESFET having a gate length of 0.5 μm with a high reproducibility, so it is more difficult to make an IC of a MESFET with a short gate length. According to the method described above, however, an active layer with a short effective gate length can be obtained with a high reproducibility as well as a high yield. Since masks 48 and 50 are only used as a masking material for ion implantation, any other materials capable of interrupting implanted ions and being readily formed and removed can be used in addition to Al. Examples of such a masking material are Au, Ti, Mo, Ta, etc.

After removing masks 48 and 50, high impurity layers 54 and 55 are selectively formed on a part to be an ohmic contact part by the ion implantation method or thermal diffusion method, preferably using mask 52 as shown in Figure 8(E); mask 52 is then removed and the implanted layer is subjected to annealing for activation. When the crystal material is a compound semiconductor such as GaAs, Inp and the like, the annealing should be carried out after coating with, e.g. $Si_3N_4$ film, and/or controlling the presence of As or P for the purpose of protecting the crystal surface.

After annealing, gate electrode 3, source electrode 4 and drain electrode 5 are formed in conventional manner to give an MESFET as shown in Figure 7.

This embodiment is commercially important since according to this embodiment, an MESFET with a short gate length and a small series resistance between the gate and source can be made easily with a high reproducibility.

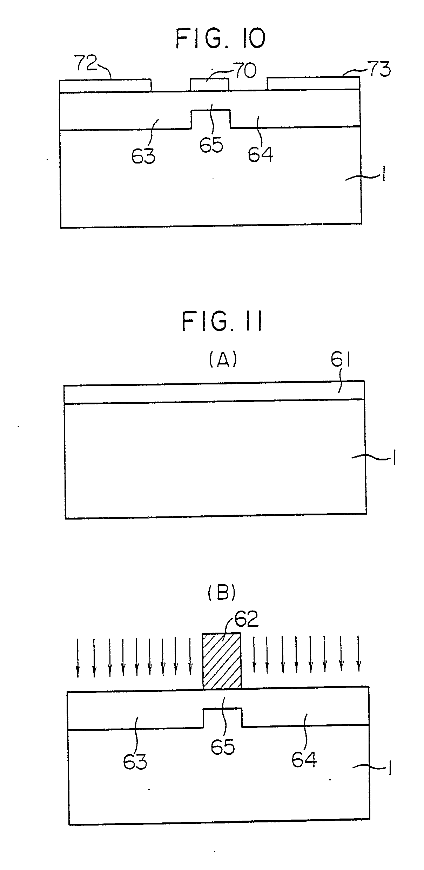

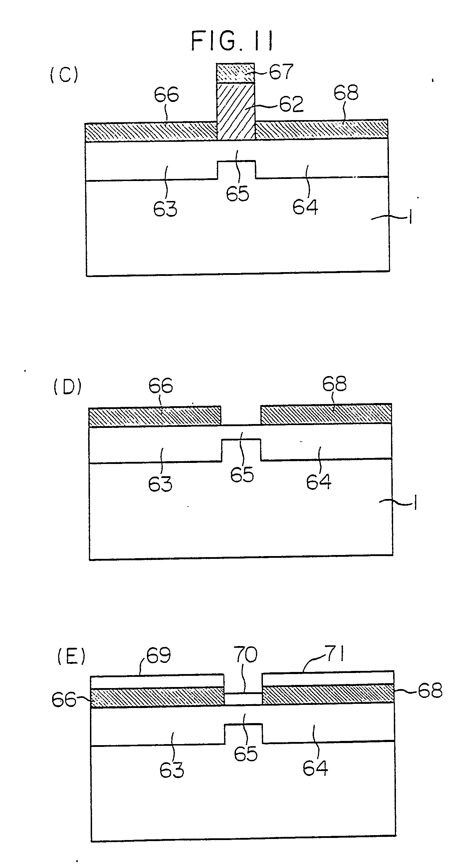

A third embodiment of the present invention will now be described with reference to Figure 10.

As illustrated in the embodiment of Figure 6, it is important for decreasing the series resistance that the gate electrode at least, covers the whole of a shallow active layer, but on the other hand, a part extending over a deep active layer due to a much larger length of the electrode than that of the shallow active layer does increase the gate capacitance and deteriorate the high frequency characteristics, and does not contribute to an effective operation of the field effect transistor. Ideally speaking, therefore, it is desirable that the shallow active layer and the gate electrode have the same length and are formed correctly at the same site.

In the MESFET of Figure 10, on semiconductor crystal substrate 1 are provided shallow active layer 65 under Schottky-barrier gate electrode 70, deep active layer 63 under source electrode 72 and under between gate and source electrodes, and deep active layer 64 under drain electrode 73 and under between gate and drain electrodes. Both shallow active layer 65 and gate electrode 70 have the same length and are formed at the same site.

Figure 11(A) to Figure 11(E) are cross sectional views illustrating a process for making an MESFET as shown in Figure 10.

Referring to Figure 11(A), on the surface of a high resistivity or semi-insulating semiconductor crystal substrate 1 is formed a one electrical conductivity type semiconductor crystal layer 61 with such a thickness and carrier concentration that a desired pinch-off voltage, e.g. +0.3 to −3 V, is obtained according to equation (1). Formation of semiconductor crystal layer 61 is generally carried out by the vapor phase epitaxial (CVD epitaxial) growth method, liquid phase epitaxial (LPE) growth method, or the method of implanting an impurity ion in the semi-insulating substrate 1. When $^{28}Si^+$ ion is implanted in a semi-insulating crystal substrate of GaAs to obtain an active layer (normally off) with a pinch-off voltage of 0 V, for example, the implantation is carried out with a $^{28}Si^+$ implantation quantity of $5.5 \times 10^{11}$ ions/cm² and an implantation voltage of 120 KeV where the doping efficiency is regarded as 100%. The carrier concentration distribution in the depth direction is shown by solid line 56 in Figure 9.

Then strip-like implantation mask 62 is formed on the surface of the above described crystal layer 61 as shown in Figure 11(B). As the material of mask 62, $SiO_2$ is suitable, but any other materials can be used which are capable of being used as a selective mask for ion implantation, and being readily formed and stripped. An impurity capable of giving the same conductivity type as crystal layer 61 is then introduced into the crystal substrate by the ion implantation method or thermal diffusion method using mask 62 to form deep active layers 63 and 64.

When the above described deep active layers 63 and 64 are formed by ion implantation, the implantation energy is made larger than that used for the ion implantation of shallow active layer 65 so as to obtain a deeper implantation than in shallow active layer 65 and the implantation quantity is preferably chosen in such a range that the final peak carrier concentration is not too large to prevent a dielectric breakdown by a voltage applied to the gate and an increase of gate capacitance. When an implantation energy of 400 KeV and an implantation quantity of $1.07 \times 10^{12}$ ions/cm² are chosen as such implantation conditions, for example, the theoretical value of the carrier concentration distribution is shown by broken line 57 in Figure 9. The concentration of non-masked parts 63 and 64 corresponds to the sum of the concentration by the first shallow ion implantation plus the concentration by the second deep ion implantation, which distribution is shown by chain line 58 in Figure 9.

As can be seen from Figure 9, the total number of carriers in deep active layers 63 and 64 is about three times higher than that in the shallow active layer 65 for giving a pinch-off voltage and, consequently, at least the gate-source resistance can be reduced to 1/3 or less as compared with the prior art method wherein active layers 63 and 64 are formed in the same manner as active layer 65. When active layer 63, 64 or 65 is formed by ion implantation, annealing is carried out for the purpose of electrically activating the ion implanted layer. During the same time, when the crystal substrate is of a compound semiconductor such as GaAs, InP and the like, the annealing should be carried out at a temperature of 700 to 850°C for several tens of minutes while protecting the surface from deterioration by the use of controlled As or P pressure.

Then, Au thin films 66, 67 and 68 are formed on the whole surface of the substrate by vapor deposition in vacuum as shown in Figure 11(C).

Thereafter, $SiO_2$ film 62 is removed by the use of an etchant containing HF while Au thin film 67 on $SiO_2$ film 62 is simultaneously removed (lift off), thus obtaining Au film patterns 66 and 68 to be a reversed image of the pattern of $SiO_2$ as shown in Figure 11(D).

A metal to form the Schottky-barrier gate electrode, for example Al, is vapor-deposited on the whole surface thereof to form films 69, 70 and 71 as shown in Figure 11(E).

Then, Au thin films 66 and 68 are removed with an etchant containing iodine while Al films 69 and 71 on Au films 66 and 68 are simultaneously removed by lift off, whereby Schottky-barrier gate electrode 70 is formed on a same site just above shallow active layer 65 as shown in Figure 11(F).

If Schottky gate electrode 70 is not subjected to correct alignment and is somewhat shifted, there arises a part of shallow active layer 65 on which there is no Schottky gate electrode and the series resistance of this part is large. The method above described has the advantage that due to self-alignment there is no such misalignment.

Finally, source electrode 72 and drain electrode 73 are formed in known manner to thus obtain an MESFET as shown in Figure 10.

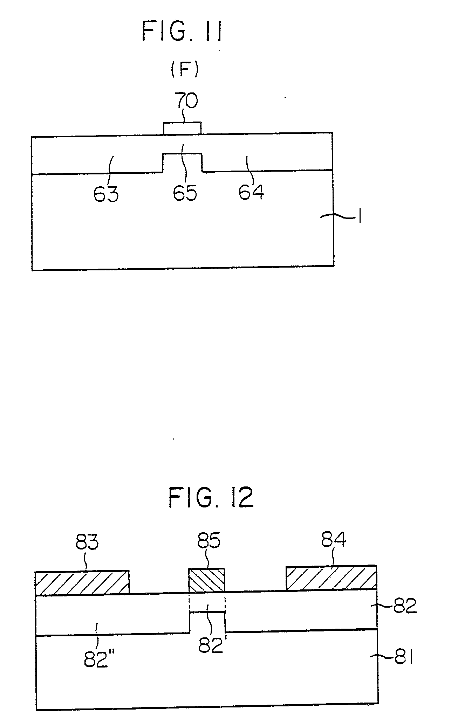

A fourth embodiment of the present invention will now be described, this embodiment having the same advantages as the third embodiment. Thus, the cross sectional view of this fourth embodiment is similar to that of the third embodiment, as shown in Figure 12.

The MESFET of Figure 12 comprises semi-insulating semiconductor substrate 81 of GaAs, n-type active layer 82, source electrode 83, drain electrode 84 and Schottky-barrier gate electrode 85. In this structure, the surface of the active layer is flat and the thickness of active layer part 82'' between the gate and source is larger than that of active layer part 82' directly under the gate. In particular, active layer part 82'' and gate electrode 85 are formed based on a same pattern of insulating material by the so-called self-alignment method and accordingly, the position of gate electrode 85 and second active layer part 82'' is precisely determined.

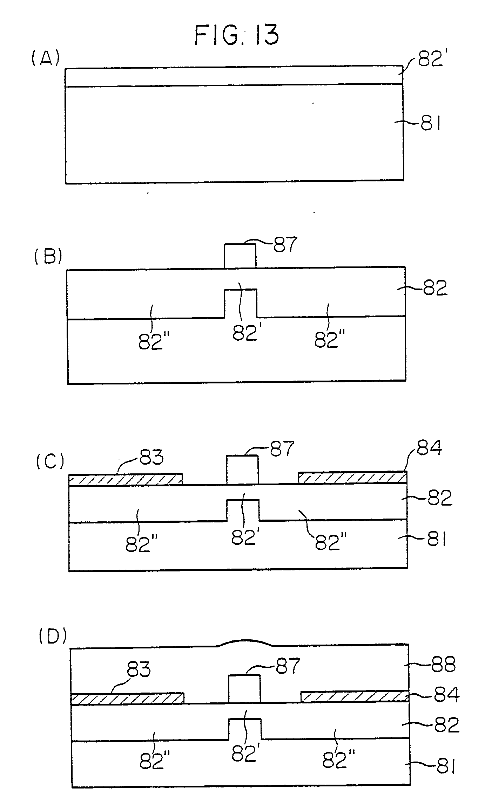

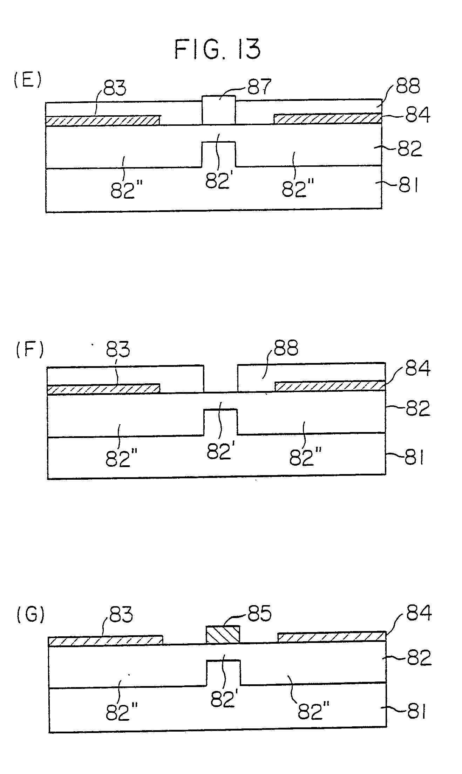

Figure 13(A) to Figure 13(G) are cross sectional views illustrating a process for making a MESFET as shown in Figure 12. Referring to Figure 13(A), on the surface of semi-insulating semiconductor crystal substrate 81 of GaAs is implanted $^{28}Si^+$ ion to form active layer 82' with a uniform thickness. The thickness and carrier concentration of this active layer are chosen so as to realize a desired pinch-off voltage, e.g. +0.3 to −3 V. For example, a carrier concentration of $10^{17}$ cm$^{-3}$ and an active layer with a thickness of 0.1 µm are approximately required for realizing a pinch-off voltage of 0 V and as ion implantation conditions, there are chosen an implantation energy of 120 KeV and an implantation quantity of $5.5 \times 10^{11}$ ions/cm$^2$ where the doping efficiency is regarded as 100%. The theoretical value of the carrier concentration distribution obtained under these conditions is shown by solid line 56 in Figure 9.

As exemplified in Figure 13(B), active layer 82' with a uniform thickness is formed and then pattern 87 consisting of an insulating material is formed thereon. Using this pattern 87 as a mask, a second ion implantation is carried out to form a new active layer part 82'' on the non-masked site under such conditions that the implantation energy is made larger than that used in the first ion implantation so as to obtain a deeper implantation than in the first ion implantation and the implantation quantity is chosen in such a range that the final peak carrier concentration is not too large to prevent dielectric breakdown by a voltage applied to the gate and an increase of gate capacitance. When an implantation energy of 400 KeV and an implantation quantity of $1.07 \times 10^{12}$ ions/cm$^2$ are chosen as such implantation conditions, for example, the theoretical value of the carrier concentration distribution is shown by broken line 57 in Figure 9.

The concentration of non-masked active layer part 82'' in active layer 82 corresponds to the sum of the concentration by the first ion implantation and that by the second ion implantation, which distribution is shown by chain line 58 in Figure 9.

In this embodiment, silicon nitride is used for the masking pattern 87. A silicon nitride film of 1.2 µm in thickness is formed by the plasma CVD method and using a resist pattern formed thereon as a mask, it is subjected to plasma etching with a mixed gas of $CF_4$ and $O_2$ (5%) to obtain pattern 87 shown in Figure 13(B).

While holding pattern 87 as it is, the implanted element is electrically activated by annealing and source electrode 83 and drain electrode 84 are formed on predetermined sites of active layer 82 as shown in Figure 13(C). Thereafter, a reversal pattern 88 to masking pattern 87 is made of an organic resin film having a thickness same as or less than that of pattern 87. To this end, a positive resist is coated in a thickness of about 2.5 µm so as to be almost flat as shown in Figure 13(D) and the whole surface is subjected to plasma etching with $O_2$ gas to reduce the thickness thereof by 1.5 µm, thus obtaining a thickness slightly lower than the upper surface of pattern 87 as shown in Figure 13(E).

The only pattern 87 is removed to obtain a resist pattern shown in Figure 13(F). In this embodiment, silicon nitride pattern 87 only is selectively removed by plasma etching using a mixed gas of $CF_4$ and $O_2$ (5%) and pattern 88 positive-negative reversed to pattern 87 is precisely formed. Finally, the process is completed by forming gate electrode 85 on the part from which pattern 87 is removed, as shown in Figure 13(G).

A fifth embodiment of the present invention, which has the same advantages as the third and fourth embodiments, will now be described.

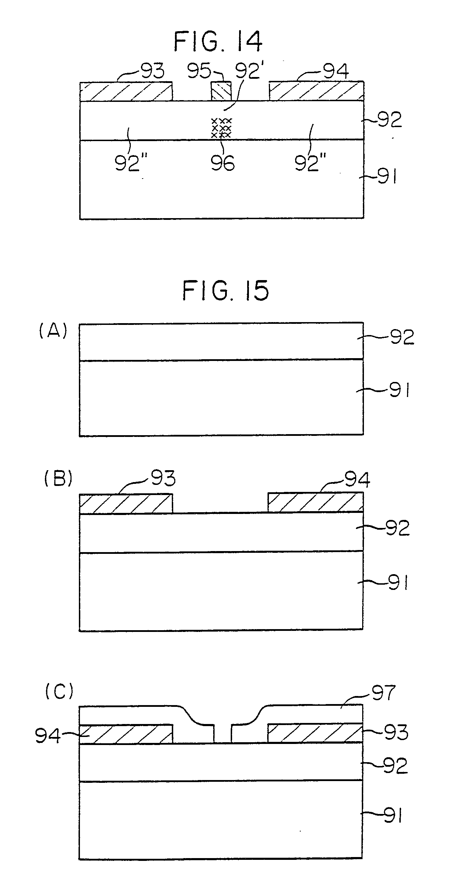

Figure 14 is a cross sectional view of a fifth embodiment of MESFET according to the present invention, which comprises semi-insulating semiconductor substrate 91 of GaAs, n-type active layer 92, source electrode 93, drain electrode 94, Schottky-barrier gate electrode 95 and a part 96 of n-type active layer 92 inactivated (insulated) by ion implantation. In this structure, the surface of the active layer is flat and the thickness of active layer part 92'' between the gate and source is larger than that of active layer part 92' directly under the gate. In particular, active layer part 92' directly under the gate and gate electrode 95 are formed based on the same pattern of insulating material by the so-called self-alignment method and accordingly, the position of gate electrode 95 and second active layer part 92'' is precisely determined.

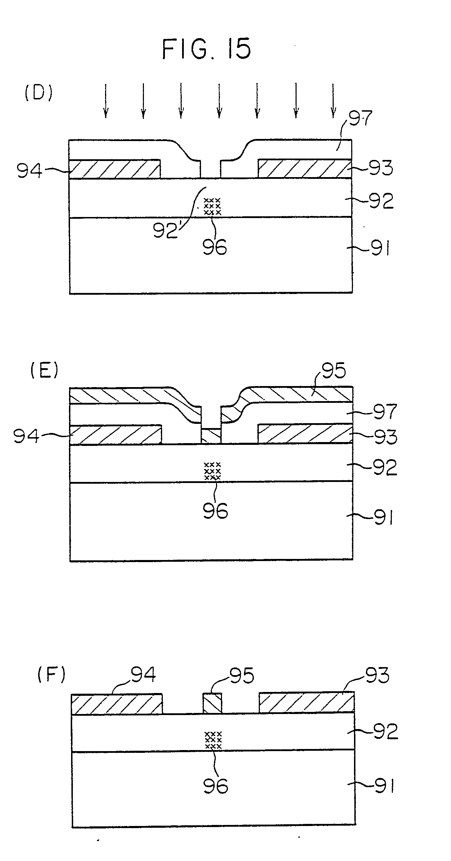

Figure 15(A) to Figure 15(F) are cross sectional views illustrating a process for making a MESFET as shown in Figure 14. Referring to Figure 15(A), on the surface of semi-insulating semiconductor crystal substrate of GaAs 91 is formed active layer 92 with a uniform thickness by vapor phase or liquid phase growth or implantation of $Si^+$ or the like. The thickness and carrier concentration of this active layer are selected so as to give a low gate-source resistance.

In a case where the active layer is formed by ion implantation, the implanted element is electrically activated by annealing and source electrode 93 and drain electrode 94 are formed on a predetermined site of active layer 92 as shown in Figure 15(B). Then masking pattern 97 for forming gate electrode 95 and inactivated zone 96 is made of, for example, a photoresist, as shown in Figure 15(C). Using this pattern 97 as a mask, an ion implantation for the inactivation is carried out as shown in Figure 15(D). As the ion to be implanted, there can be used any of ions capable of inactivating the active layer 92 without losing the inactivating function even after forming of gate electrode 95.

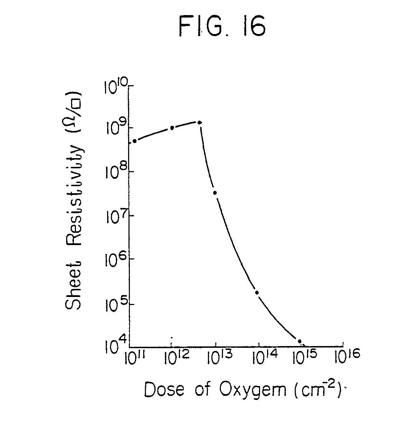

In this embodiment, oxygen is used as the inactivating ion. Figure 16 shows a state in which the resistance of an active layer with a sheet resistance of 150 $\Omega/\square$ is varied by implantation of $O^+$ ion. Besides oxygen, chromium or boron can otherwise be used as the inactivating ion. The pinch-off voltage can be adjusted to a desired value by implantation of such an inactivating ion to reduce the effective length of active layer part 92' or to decrease the carrier concentration.

Thereafter, a metal for gate electrode 95 is vapor-deposited as shown in Figure 15(E) and masking pattern 97 is removed (lift off method), thus forming gate electrode 95 as shown in Figure 15(F).

As the material of masking pattern 97 there can be used any materials capable of serving as a mask for ion implantation and being removed selectively to retain a gate electrode, for example, not only photoresists but also materials not reactive with semiconductors, such as organic resin films or inorganic compounds, e.g. silicon oxide, aluminum oxide and aluminum nitride.

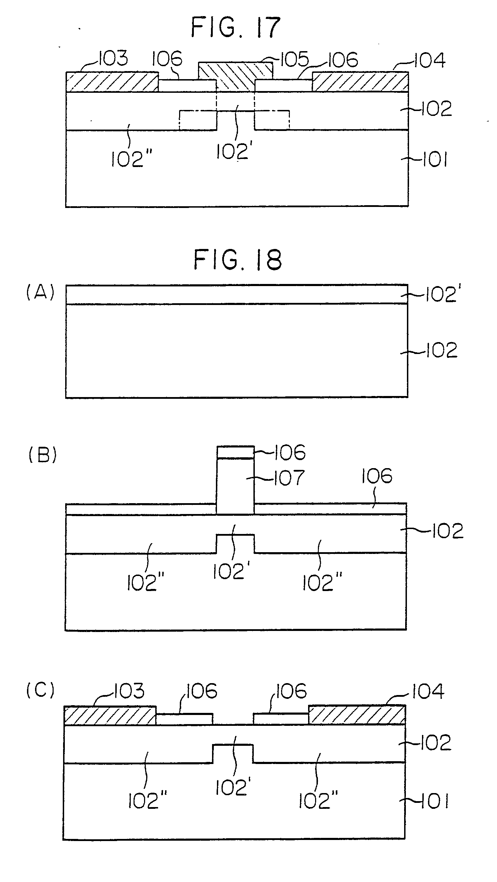

A sixth embodiment of the present invention, which has the same advantages as the third to fifth embodiments, will now be described. Figure 17 is a cross-sectional view of a sixth embodiment of MESFET according to the present invention, which comprises semi-insulating semiconductor substrate of GaAs 101, n-type active layer 102, source electrode 103, drain electrode 104, Schottky-barrier gate electrode 105 and insulating film 106. In this structure, the surface of the active layer 102 is flat and the thickness of active layer part 102'' between the gate and source is larger than that of active layer part 102' directly under the gate. In particular, active layer part 102'' and gate electrode 105 are formed based on the same pattern of insulating material by the so-called self-alignment method and accordingly, the position of gate electrode 105 and second active layer part 102'' is precisely determined. Thus, not only the production process is simple but also the yield is increased and at the same time, a fine patterning is possible.

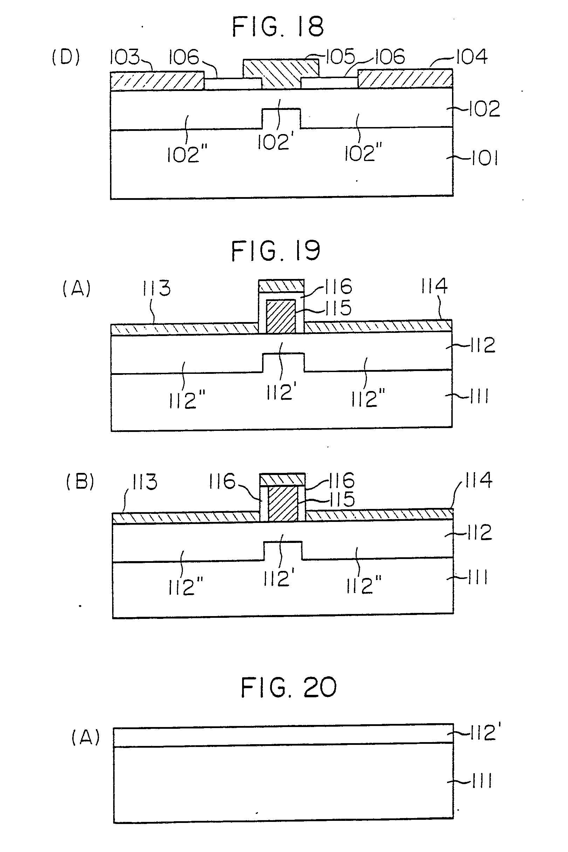

Figure 18(A) to Figure 18(D) are cross sectional views illustrating a process of making a MESFET according to the present invention as shown in Figure 17. As shown in Figure 18(A), in the surface of semi-insulating semiconductor crystal substrate of GaAs 101 is implanted $^{28}Si^+$ ion to form active layer 102' with a uniform thickness. The thickness and carrier concentration of this active layer are so selected that a desired pinch-off voltage, e.g. +0.3 to −3 V, is obtained. For example, a carrier concentration of about $10^{17}$ $cm^{-3}$ and an active layer with a thickness of about 0.1 μm are required for realizing a pinch-off voltage of −2.2 V and as ion implantation conditions, there are chosen an implantation energy of 120 KeV and an implantation quantity of $2 \times 10^{12}$ ions/$cm^2$ where the doping efficiency is regarded as 100%. The theoretical value of the carrier concentration distribution obtained under these conditions is shown by chain line 31 in Figure 5.

As exemplified in Figure 18(B), active layer 102' with a uniform thickness is formed and then pattern 107 consisting of an insulating material is formed thereon. Using this pattern 107 as a mask, a second ion implantation is carried out to form an active layer part 102'' on the non-masked site under such conditions that the implantation energy is made larger than that used in the first ion implantation so as to obtain a deeper implantation than in the first ion implantation and the implantation quantity is chosen in such a range that the final peak carrier concentration is not too large to prevent dielectric breakdown by a voltage applied to the gate and an excessive increase of gate capacitance. When an implantation energy of 400 KeV and an implantation quantity of $3.9 \times 10^{12}$ ions/$cm^2$ are chosen as such implanting conditions, for example, the theoretical value of the carrier concentration distribution is shown by broken line 32 in Figure 5. The concentration of non-masked part 102'' in active layer 102 corresponds to the sum of the concentration by the first ion implantation and that by the second ion implantation, which distribution is shown by solid line 33 in Figure 5.

As can be seen from Figure 5, the total number of carriers in deep active layer part 102'' near source electrode 103 is about three time higher than that in active layer part 102' directly under gate electrode 105 and, consequently, the gate-source resistance can be reduced to 1/3 or less as compared with the case where active layer 102' is uniformly formed. On the other hand, since the peak carrier concentration in active layer part 102'' becomes only about 13% more than that in active layer part 102', decrease of the breakdown voltage of the gate and increase of the capacitance of the gate are held small.

As masking pattern 107, for example, silicon

oxide film (SiO$_2$) can be used. For example, an SiO$_2$ film with a thickness of 1.2 μm is formed and using a resist pattern formed thereon as a mask, it is subjected to plasma etching with C$_3$F$_8$ gas, thus obtaining pattern 107 shown in Figure 18(B). As the material of masking pattern 107 there can be used any materials capable of serving as a mask for ion implantation or thermal diffusion and being removed selectively from insulating film 106.

On the other hand, an insulating film 106 having a resistance to a high temperature process such as annealing can be used. Therefore, the material is not limited to silicon nitride only, but materials excellent in heat resistance and not reactive with semiconductors at a high temperature, e.g. 800°C, can also be used, for example, inorganic compounds such as silicon oxide, aluminum oxide and aluminum nitride.

Insulating film 106 is provided on the whole surface of the structure as shown in Figure 18(B). For example, silicon nitride film 106 is deposited in a thickness of 0.2 μm on the whole surface of the structure by the plasma CVD method, followed by annealing, to thus activate electrically the implanted element.

Thereafter, source electrode 103 and drain electrode 104 are formed as shown in Figure 18(C). For example, as shown in Figure 18(C), SiO$_2$ film 107 is removed with a buffered HF solution to obtain, and the film 106 is then subjected to window-making (selective etching) by the ordinary photolithography and CF$_4$ plasma etching, followed by forming source electrode 103 and drain electrode 104.

Finally, gate electrode 105 is formed by the use of the ordinary vapor deposition and lithographic technique as shown in Figure 18(D).

It is to be noted herein that for the formation of gate electrode 105, a window is formed in film 106 correctly aligned with active layer part 102' in the preceding step, so the gate electrode 105 is directly aligned with active layer part 102' and does not overlap with active layer part 102''. Thus, as illustrated hereinafter, a MESFET excellent in microwave characteristics and without any unnecessary increase of electrostatic capacitance can be obtained.

An example of making a field effect transistor having the structure shown in Figure 17 by the ion implantation method has been described above, but it can otherwise be produced by a thermal diffusion method. That is, a shallow diffusion layer corresponding to active layer part 102' of Figure 18(A) is firstly formed by contacting a dopant with a small diffusion constant with the surface of a substrate, followed by thermal diffusion, a mixed diffusion layer consisting of a shallow diffusion layer and a deep diffusion layer, corresponding to active layer part 102'' of Figure 18(B), is then formed by contacting another dopant with a large diffusion constant with the site except directly under the gate, using masking pattern 107 as a shield, followed by thermal diffusion, and finally, electrodes 103, 104 and 105 are formed in an analogous manner to the above described embodiment. Alternatively, the structure of Figure 17 can be realised by depositing a dopant with a small diffusion constant on a gate part while depositing another dopant with a large diffusion constant between the gate and source, and then subjecting both the parts to thermal diffusion simultaneously.

The shorter is the length of active layer part 102' in Figure 17, the smaller is the series resistance between the gate and source. This is a favourable character. However, shortening of this length is limited by the fine photolithography used for production of the electrodes.

The relationship between the length of active layer part 102' and that of the Schottky contact of gate electrode 105 will now be described. In the case of a "normally on" type, which has a relatively thick active layer part 102', even if the length of active layer part 102' is somewhat longer than that of gate electrode 105, the properties are not significantly deteriorated, because the problem does not arise that the part of active layer part 102' not directly under the gate increases extremely the resistance between the gate and source since active layer part 102' is relatively thick, and accordingly the thickness of a depletion layer from the surface does not extend the whole thickness of the active layer part 102'. On the contrary, in the case of a "normally off" type, in which the shallow active layer part 102' is relatively thin, if the length of the shallow active layer part 102' is greater than that of gate electrode 105, the depletion layer not directly beneath the gate will extend completely to the bottom of the shallow active layer part thus resulting in the problem that the resistance between the gate and source is markedly increased and in an extreme case, electric current flow is completely interrupted.

In the "normally off" type, therefore, the length of gate electrode 105 should be larger than that of active layer part 102'. However, in the Schottky contact of gate electrode 105, a part thereof exceeding the length of active layer 102' increases only the electrostatic capacity and has no effective function, and, accordingly, it is desirable in order to increase the operation speed of the element to hold the exceeding part as short as possible. That is, ideally, it is effective to form the Schottky junction of gate electrode 105 and active layer 102' to have equal lengths as shown in Figure 17.

With embodiments of the present invention, the characteristics of "normally off" type can remarkably be improved because active layer part 102' and Schottky contact of gate electrode 105 are formed on the same site and with the same length with self-alignment using insulating film 107.

A seventh embodiment of the present invention will now be described.

Figure 19(A) and Figure 19(B) are cross sectional views of a seventh embodiment of MESFET according to the present invention, which comprises semi-insulating semiconductor substrate

**0 057 605**

of GaAs 111, n-type active layer 112, source electrode 113, drain electrode 114, Schottky-barrier gate electrode 115 stable at high temperatures and insulating compound film 116. In the structures of Figure 19(A) and (B), the surface of the active layer is level and the thickness of active layer part 112'' between the gate and source is larger than that of active layer part 112' directly under the gate. In particular, active layer 112'' is formed using gate electrode as a mask and source electrode 113 and drain electrode 114 are formed through insulating compound film 116 by the so-called self-alignment method. Accordingly, the position relationship of source electrode 113, drain electrode 114 and gate electrode 115 with second active layer part 112'' is precisely determined. Thus, not only the production process is simple but also the yield is increased and at the same time, a fine patterning for the electrodes is possible.

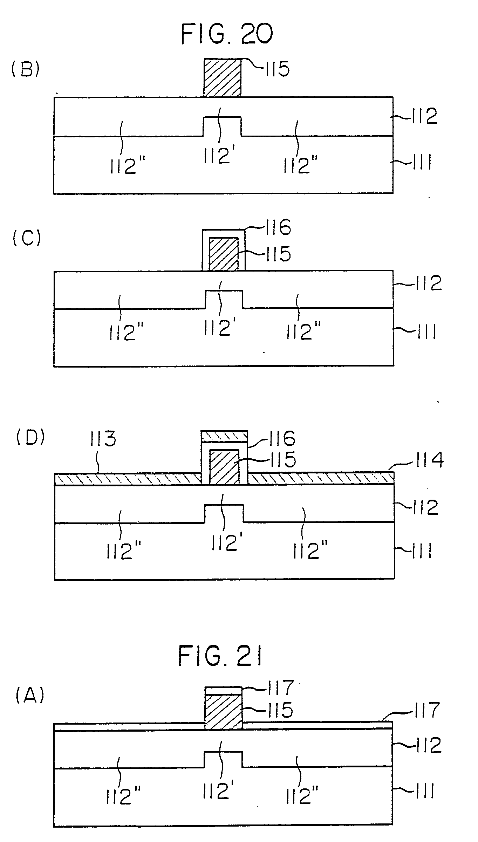

Figure 20(A) to Figure 20(D) are cross sectional views illustrating a process for producing a MESFET according to the present invention as shown in Figure 19(A). As shown in Figure 20(A), in the surface of semi-insulating semiconductor crystal substrate of GaAs 111 is implanted $^{28}Si^+$ ion to form active layer 112' with a uniform thickness. The thickness and carrier concentration of this active layer are so selected that a desired pinch-off voltage, e.g. +0.3 to −3 V be obtained. For example, a carrier concentration of about $10^{17}$ $cm^{-3}$ and an active layer with a thickness of about 0.1 µm are required for realising a pinch-off voltage of −2.2 V and as ion implantation conditions, there are chosen an implantation energy of 120 KeV and an implantation quantity of $2 \times 10^2$ ions/cm² where the doping efficiency is regarded as 100%. The theoretical value of the carrier concentration distribution obtained under these conditions is shown by chain line 31 in Figure 5.

After forming active layer 112' with a uniform thickness, gate electrode 115 consisting of a metal stable at high temperatures is formed thereon as shown in Figure 20(B). Using this gate electrode 115 as a mask, a second ion implantation is carried out to form an active layer part 112'' on the non-masked site under such conditions that the implantation energy is made larger than that used in the first ion implantation so as to obtain a deeper implantation than in the first ion implantation and the implantation quantity is chosen in such a range that the final peak carrier concentration is not too large to prevent dielectric breakdown by a voltage applied to the gate and to prevent an excessive increase of the gate capacitance. When an implantation energy of 400 KeV and an implantation quantity of $3.9 \times 10^{12}$ ions/cm² are chosen as such implanting conditions, for example, the theoretical value of the carrier concentration distribution is shown by broken line 32 in Figure 5. The concentration of non-masked part 112'' in active layer 112 corresponds to the sum of the concentration by the first ion implantation plus that by the second ion implantation, which distribution is shown by solid line 33 in Figure 5.

As can be seen from Figure 5, the total number of carriers in active layer part 112'' near source electrode 113 is about three times higher than that in active layer part 112' directly under gate electrode 115 and, consequently, the gate-source resistance can be reduced to about 1/3 or less as compared with the case where active layer 112 is uniformly formed. On the other hand, since the peak carrier concentration in active layer part 112'' becomes only about 13% more than that in active layer part 112', decrease of the breakdown voltage of the gate and increase of the gate capacitance are held very small.

In this embodiment, Ti-W alloy is used for gate electrode 115. For example, a Ti-W alloy film with a thickness of 1.2 µm is formed by sputtering and using a resist pattern formed thereon as a mask, it is subjected to plasma etching with a mixed gas of $CF_4$ and $O_2$ (5%), thus obtaining gate electrode 115 as shown in Figure 20(B). Using this electrode as a mask, ion implantation is carried out to form second active layer part 112'', followed by electrically activating the implanted element.

As shown in Figure 20(C), on the whole surface of gate electrode 115 is formed an insulating compound film 116 having the gate metal itself as a basic material. In this embodiment, the surface of the gate electrode becomes an insulator by plasma anode oxidation to form an insulating compound film having a thickness of 200 nm (2000 Å). At this time, the surface of the semiconductor substrate is oxidised, but it is easy to remove the GaAs oxide film selectively from insulating compound film 116 on the gate electrode.

Then the production process is completed by forming an ohmic metal film on active layer 112 by vapor deposition in vacuum as shown in Figure 20(D) and thus obtaining source electrode 113 and drain electrode 114.

Figure 21(A) to Figure 21(C) are cross-sectional views illustrating a process for making a MESFET according to the present invention as shown in Figure 19(B). After forming gate electrode 115 as shown in Figure 20(A) and Figure 20(B), inorganic compound film 117 is formed on the surface of the structure as exemplified in Figure 21(A) and annealed to activate electrically the implanted element. In this embodiment, an SiO film of 150 nm (1500 Å) in thickness, formed by vapor deposition in vacuum, is used as inorganic compound film 117. As the material of film 117 there can be used any insulating compounds which do not react with semiconductor substrate 112 and gate electrode 115 during annealing and there is no particular limitation as to material and forming method.

When the structure is subjected to plasma anodic oxidation as shown in Figure 21(B), the plasma oxidation proceeds only on both sides of gate electrode 115 not covered with inorganic compound film 117, and thus insulating compound film 116 is formed on both sides of gate electrode 115 by chemically altering the gate electrode.

Then the production process is completed by removing inorganic compound film 117, depositing an ohmic metal by vapor deposition in vacuum and thus forming source electrode 113 and drain electrode 114, as shown in Figure 21(C).

In the step of Figure 21(B), second active layer part 112' is formed by ion implantation and thereafter, a high concentration layer of about $10^{18}$ $cm^{-3}$, i.e. so-called $n^+$ layer can be formed near the surface only. This is an effective means for improving the ohmic properties of source electrode 113 and drain electrode 114.

Since gate electrode 115 serves as a mask for ion implantation or thermal diffusion and has a resistance to a high temperature process such as annealing or the like, as the material thereof there can be used not only Ti-W alloys but also materials not reactive with semiconductors even at a high temperature, e.g. about 800°C and excellent in heat resistance, for example, metals such as Ta, Nb, V, Mo and the like. Surface insulation of gate electrode 115 is not limited to the plasma oxidation employed in this embodiment, but can be carried out by formation of an oxide film such as by anodic oxidation or thermal oxidation, or by formation of a nitride film such as by plasma nitrification.

Examples of making a field effect transistor having the structures shown in Figure 19(A) or Figure 19(B) by ion implantation have been described above, but they can otherwise be produced by the thermal diffusion method. That is, a shallow diffusion layer corresponding to active layer part 112' of Figure 19(A) is firstly formed by contacting a dopant with a small diffusion constant with the surface of the substrate, followed by thermal diffusion, a mixed diffusion layer consisting of a shallow diffusion layer and a deep diffusion layer, corresponding to active layer part 112'' of Figure 20(B) is then formed by contacting another dopant with a large diffusion constant with the parts except directly under the gate using masking pattern 117 as a shield, followed by thermal diffusion, and finally, electrodes 113, 114 and 115 are formed in an analogous manner to the above described embodiment. Alternatively, the structures of Figure 19(A) and Figure 19(B) can be realised by depositing a dopant with a small diffusion constant on a gate part while depositing another dopant with a large diffusion constant between the gate and source, and then subjecting both parts to thermal diffusion simultaneously.

As apparent from the foregoing, in the seventh embodiment of the present invention, the same effect or merits can be obtained as in the first to sixth embodiments and the gap between gate electrode 115 and source electrode 113 can be decreased more remarkably. That is to say, the source series resistance can be reduced to a very small value because the electrodes are separated by insulating film 116 only which can be formed with a thickness of several hundreds of nm (several thousands Å).

An eighth embodiment of the present invention will now be described.

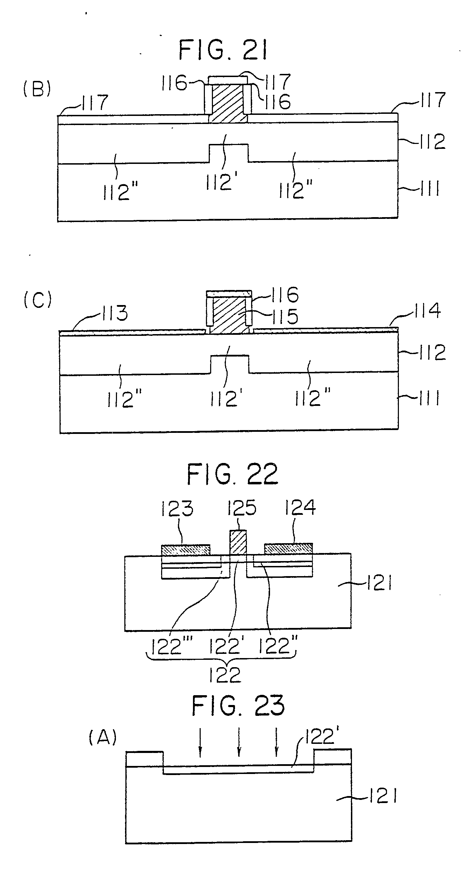

Figure 22 is a cross sectional view of an eighth embodiment of MESFET according to the present invention, which comprises semi-insulating semiconductor substrate of GaAs 121, n-type active layer 122, source electrode 123, drain electrode 124 and Schottky gate electrode 125. In the structure of Figure 22, the surface of the active layer is flat and the thickness of active layer part 122'' between the gate and source is larger than that of active layer part 122' directly under the gate. In particular, gate electrode 125, ohmic implanted zone and deep implanted zone are formed with self-alignment. This embodiment has various advantages, i.e. a small source resistance, simple production process, increased yield, possibility of fine working, etc.

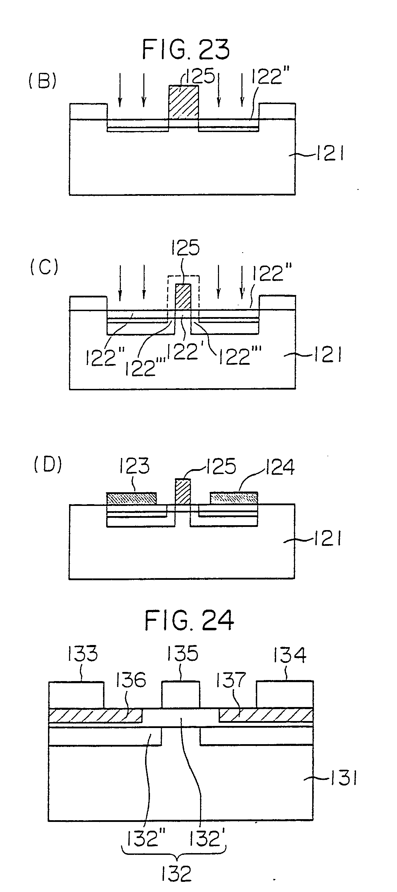

Figure 23(A) to Figure 23(D) are cross sectional views illustrating a process for making a MESFET as shown in Figure 23(A). Firstly, $^{28}Si^+$ ion is implanted in the surface of semi-insulating semiconductor crystal substrate of GaAs 121 to form active layer 122' with a uniform thickness. The thickness and carrier concentration of this active layer as so selected that a desired pinch-off voltage, e.g. +0.3 to −3 V be obtained. For example, a carrier concentration of about $10^{17}$ $cm^{-3}$ and an active layer with a thickness of about 0.1 μm are required for realising a pinch-off voltage of −2.2 V and as ion implantation conditions, there are chosen an implantation energy of 120 KeV and an implantation quantity of $2 \times 10^{12}$ ions/cm² where the doping efficiency is regarded as 100%. The theoretical value of the carrier concentration distribution is shown by chain line 31 in Figure 5.

After forming active layer 122' with a uniform thickness, strip-like pattern 125 consisting of a high melting point metal such as TiW is formed thereon as shown in Figure 23(B). Using this pattern 125 as a mask, a second ion implantation is carried out to form $n^+$ layer 122'' having a large carrier concentration in the non-masked parts. The conditions of the second ion implantation are that the carrier concentration of the surface is so large, for example, an implantation energy of 50 KeV and implantation quantity of $2 \times 10^{13}$ ions/cm², that a good ohmic electrode is formed.

As shown in Figure 23(C), the surface of high melting point metal pattern 125 is etched with an isotropic etchant such as phosphoric acid or dilute hydrofluoric acid to reduce the pattern width. Using this pattern as a mask, a third ion implantation is carried out to form active layer part 122'' having a carrier concentration substantially similar to that of active layer part 122' and a thickness larger than that of active layer part 122' in a part 122''' between $n^+$ layer 122'' and metallic pattern 125. The conditions of the third ion implantation are that the implantation energy is made larger than that used in the first ion implantation and the implantation quantity is chosen in such a range that the final peak carrier concentration is not too large to prevent dielectric breakdown by a voltage applied to the gate and to prevent an excessive increase of the gate capacitance. When an implantation energy of 400 KeV and an implantation quantity of $3.9 \times 10^{12}$ ions/$cm^2$ are chosen as such implanting conditions, for example, the theoretical value of the carrier concentration distribution is shown by broken line 32 in Figure 5. The concentration of active layer part 122''' corresponds to the sum of the concentration by the first ion implantation plus the concentration by the third ion implantation, which distribution is shown by solid line 33 in Figure 5.

As can be seen from Figure 5, the total number of carriers in active layer part 122''' is about three times higher than that in active layer part 122' directly under gate electrode 125 and, consequently, the gate-source resistance can be reduced to about 1/3 or less as compared with the case where active layer part 122''' is uniformly formed to be same as active layer part 122'. On the other hand, since the peak carrier concentration in active layer part 122''' becomes only about 13% more than that in active layer part 122', decrease of the breakdown voltage of the gate and increase of the gate capacitance are held very small.

A heat treatment is then carried out at 800°C for 20 minutes in an $N_2$ atmosphere to effect electrical activation of the implanted ion. Finally, ohmic electrodes are formed on the ohmic zones as shown in Figure 23(D), thus obtaining a field effect transistor.

It is preferable that the length of active layer part 122' in Figure 22 is as short as possible. However, shortening of this length is limited by the fine photolithography used for electrode formation.

The relationship between the length of active layer part 122' and that of gate electrode 125 will now be illustrated. In the case of a "normally on" type, which has a relatively thick active layer part 122', even if the length of active layer part 122' is somewhat longer than that of gate electrode 125, the properties are not significantly deteriorated, because the problem does not arise that the part of active layer part 122' not directly under the gate increases extremely the resistance between the gate and source since active layer part 122' is relatively thick and accordingly, the thickness of a depletion layer from the surface toward the inside does not extend the whole thickness of active layer part 122'.

On the contrary, in the case of a "normally off" type, in which the shallow active layer part 122' is relatively thin, if the length of the shallow active layer part 122' is greater than that of gate electrode 125, the depletion layer in the region not directly beneath the gate will extend completely to the bottom of the shallow active layer part, thus resulting in such a problem that the resistance between the gate and source is markedly increased and in an extreme case, electric current is completely interrupted.

In the "normally off" type, therefore, the length of gate electrode 125 should be larger than that of active layer part 122'. However, any part of gate electrode 125, exceeding the length of active layer part 122' increases only the electrostatic capacity and has no effective function and, accordingly, it is desirable to hold the exceeding part as short as possible so as to increase the operation speed of the element. That is, ideally, it is effective to form gate electrode 125 and active layer part 122' to have equal length as shown in Figure 22, in particular, in the "normally off" type.

According to this embodiment, using gate electrode 125 as a mask, an $n^+$ layer is formed and a deep ion implantation is carried out, so the gate electrode, deep implanted layer and $n^+$ layer are formed through self-alignment. Thus active layer 122' and gate electrode 125 are formed on the same site and with the same length and moreover, $n^+$ layer 122'' and gate electrode 125 are formed in an adjacent position, thus resulting in a further decreased source series resistance and remarkably improved characteristics of the "normally off" type.

A ninth embodiment of the present invention will now be described.

Figure 24 is a cross sectional view of a MESFET according to the present invention, which comprises semi-insulating semiconductor substrate of GaAs 131, n-type active layer 132, source electrode 133, drain electrode 134 and Schottky-barrier gate electrode 135. In the structure of Figure 24, the surface of the active layer is flat and the thickness of active layer part 132'' between the gate and source is larger than that of active layer part 132' directly under the gate. Gate electrode 135 is correctly positioned to exactly coincide with active layer part 132' without overlapping any of active layer part 132'', and $n^+$ layers 136 and 137 are formed at both sides of gate electrode 135 to extend about 0.5 μm.

According to this embodiment of MESFET, as described above, thick active layer part 132'' and $n^+$ layer are provided between gate electrode 135 and source electrode 133 and $n^+$ layer 136 and gate electrode 135 are provided to be sufficiently adjacent, for example, by about 0.5 μm, to obtain a low source resistance and good high frequency characteristics.

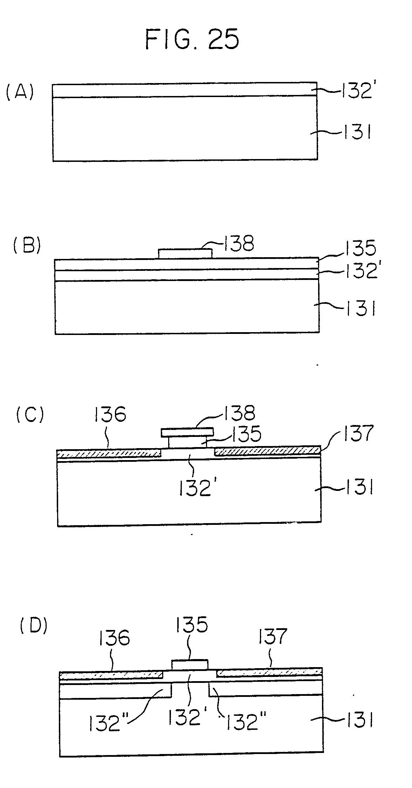

Figure 25(A) to Figure 25(D) are cross-sectional views illustrating an example of a process for the production of a MESFET according to the present invention shown in Figure 24. As shown in Figure 25(A), $^{28}Si^+$ ion is implanted in the surface of semi-insulating substrate of GaAs 131 to form active layer 132' with a uniform thickness. The thickness and carrier concentration of this active layer are selected suitably so as to give a desired pinch-off voltage, e.g. +0.3 to −3 V. For example, a carrier concentration of about $10^{17}$ $cm^{-3}$ and an active layer of about 0.1 μm in thickness are required for realising a pinch-off voltage of 12.2 V and as ion implantation conditions, there are chosen an implantation energy of 120 KeV and an implantation quantity of $2 \times 10^{12}$ ions/$cm^2$ where the doping efficiency is regarded as 100%. The theoretical value of the carrier concentration distribution obtained under these conditions is shown by chain line 31 in Figure 5.

After forming active layer 132' with a uniform thickness, a high melting point metal 135 not reactive with GaAs, such as Ti, Ta, W, V, Nb, Mo or alloys thereof, is vapor-deposited on active layer 132' and further photoresist pattern 138 is formed thereon, as shown in Figure 25(B). Using this photoresist pattern 138 as a mask, metal 135 is subjected to etching and further to side etching to form a metal pattern 135 narrower than photoresist pattern 138 under this pattern 138, as shown in Figure 25(C). Thereafter, using this photoresist pattern 138 as a mask, a second ion implantation is carried out to form $n^+$ layers 136 and 137 on the non-masked sites.

Then resist 138 is removed and using pattern 135 as a mask, a third ion implantation is carried out to form a new active layer part 132'' on the non-masked sites, as shown in Figure 25(D). The ion implanting conditions of the third implantation are that the implantation energy is made larger than that used in the first ion implantation and the implantation quantity is chosen in such a range that the final peak carrier concentration is not too large to prevent dielectric breakdown by a voltage applied to the gate and to prevent an excessive increase of the gate capacitance. When an implantation energy of 400 KeV and an implantation quantity of $3.9 \times 10^{12}$ ions/cm$^2$ are chosen as such implanting conditions, for example, the theoretical value of the carrier concentration distribution is shown by broken line 32 in Figure 5. The concentration ion part 132'' where the second ion implantation has not been carried out, of the non-masked part of active layer 132, corresponds to the sum of the concentration by the first ion implantation and that by the third ion implantation, which distribution is shown by solid line 33 in Figure 5.

As can be seen from Figure 5, the total number of carriers in active layer part 132'' between $n^+$ layer 136 or 137 and active layer part 132' is about three times higher than that in active layer part 132' directly under gate electrode 135 and, consequently, the gate-source resistance can be reduced to about 1/3 or less as compared with the case where active layer part 132'' is uniformly formed to be the same as active layer part 132'. On the other hand, since the peak carrier concentration in active layer part 132'' becomes only about 13% more than that in active layer part 132', decrease of the breakdown voltage of the gate and increase of the gate capacitance are held very small.

Electrical activation of the implanted element is then carried out by annealing and source electrode 133 and drain electrode 134 are formed on predetermined sites of $n^+$ layers 136 and 137, thus obtaining a MESFET as shown in Figure 24.

According to this embodiment of the present invention, the characteristics of "normally off" type can remarkably be improved, because active layer part 132' and gate electrode 135 are formed on the same site and with the same length through self-alignment by carrying out ion implantation using pattern 135 as a mask.

The shorter is the length of active layer part 132'' between $n^+$ layer 136 or 137 and active layer part 132', the smaller is the series resistance between the gate and source. This gives a favourable performance. In this embodiment, the length of active layer 132'' depends on the contraction difference between patterns 135 and 138 and can be very small, e.g. approximately 0.5 μm.

In the foregoing embodiments of the present invention, GaAs is used as a semiconductor crystal, but if necessary, InP or other Group III—Group V compound semiconductors or other semiconductors such as Si can be used.

As apparent from the foregoing detailed description, according to the present invention, there is provided a MESFET which is excellent in high frequency characteristics, exhibits a high breakdown voltage and can be produced with a high yield, because the active layer part between the gate and source is thick, the carrier concentration is substantially constant over the whole active layer and the surface of the active layer is made flat.

**Claims**

1. A Schottky-barrier gate field effect transistor comprising a semi-insulating semiconductor substrate, an active layer formed on the surface of the semiconductor substrate, and a source electrode, Schottky-barrier gate electrode and drain electrode formed on the active layer, the active layer having a first part formed near the gate electrode and a second part of the same conductivity type as the first part, and having a larger thickness than the first part formed between the gate electrode and the source electrode, the upper surfaces of the first part and second part of the active layer being in the same plane, characterized in that the second part of the active layer has a substantially similar carrier concentration to that of the first part.

2. A transistor as claimed in claim 1, wherein the gate electrode completely covers at least the first part of the active layer.

3. A transistor as claimed in claim 1 or claim 2, wherein the source electrode is positioned on the surface of the second part of the active layer.

4. A transistor as claimed in claim 1, wherein the gate electrode is formed on the first part of the active layer through an opening in an insulating film, the gate electrode having a length at least the same as that of the first part of the active layer and being formed in the opening in the insulating film only.

5. A transistor as claimed in claim 4, wherein the insulating film is of silicon nitride, silicon oxide, aluminum oxide or aluminium nitride.

6. A transistor as claimed in any preceding claim, wherein the gate electrode consists of a metal which is stable at high temperatures and is covered with an insulating compound film formed by chemically altering the metal of the gate electrode.

7. A transistor as claimed in claim 6, wherein the gate electrode is of Ti-W alloy, Ta, Nb, V or Mo.

8. A transistor as claimed in any preceding claim, wherein the gate electrode is formed on the same site and with at least the same length as the first part and active layers having the same conductivity type and a higher carrier concentration than that of the first part are formed at both sides of the gate electrode and in the vicinity thereof, in the vicinity of the source and drain electrodes.

9. A process for the production of a Schottky-barrier gate field effect transistor, which comprises forming on a semi-insulating semiconductor substrate an active layer having a first part of one electrical conductivity type semiconductor crystal with a thickness and carrier concentration chosen so as to give a predetermined pinch-off voltage, forming a stripe-like resist pattern on the active layer, introducing an impurity for giving the same conductivity type as the active layer through the active layer by ion implantation or thermal diffusion selectively through the pattern as a mask to form a second deeper part for the active layer on both sides of the first part thereof, removing the pattern and then forming a source electrode, drain electrode and gate electrode on the resulting level active layer, characterized in that the impurity is introduced to give a substantially similar carrier concentration in the second part of the active layer as in the first part thereof.

10. A process as claimed in claim 9, wherein the active layer is formed by implanting $^{28}Si^+$ ion uniformly into a semi-insulating GaAs substrate.

11. A process as claimed in claim 9 or claim 10, wherein the pinch-off voltage is between +0.3 and −3 V.

12. A process as claimed in claim 9, including forming a pattern reversed rightly to the resist pattern by the lift off method, introducing an impurity for giving the same electrically conductive type as the active layer through the reversed pattern by slant ion implantation, removing the reversed pattern, carrying out annealing for the electrical activation of the ion-implanted impurity to form the Schottky-barrier electrode, and forming a source electrode and a drain electrode.

13. A process as claimed in claim 12, wherein the reversed pattern is formed by vapor deposition of Al, Ta, Mo, W or Ti, followed by lift off.

14. A process as claimed in claim 9, including forming a pattern reversed rightly to the stripe-like pattern by the lift off method, vapor depositing a Schottky gate metal thereon, forming a Schottky gate electrode positioned correctly on the first part of the active layer by removing the reversed pattern mask, and forming a source electrode and a drain electrode on the second part of the active layer.

15. A process as claimed in claim 14, wherein the reversed pattern is formed by vapor-deposition of Au, followed by lift off.

16. A process as claimed in claim 14 or claim 15, wherein the Schottky gate electrode is of Al, Ta, Mo, W or Ti.

17. A process as claimed in claim 9, including applying a photoresist to provide a level surface, using plasma etching to remove a part of the photoresist and to expose the upper part of the pattern from the photoresist, removing the pattern to expose only the first part of the active layer, vapor depositing a gate metal, and then removing the photoresist.

18. A process for the production of a Schottky-barrier gate field effect transistor, comprising forming on a semiconductor substrate an active layer with a uniform thickness and a planar outer surface, the active layer being of only one conductivity type and having a substantially uniform carrier concentration; forming a source electrode and a drain electrode on the surface of the active layer; forming a masking layer over the surface of the active layer and the source and drain electrodes, the masking layer having a window therein between the source and drain electrodes; implanting an inactivating ion through the window so as to form an insulating inactivated zone in the active layer and at the bottom thereof under the window while leaving the part of the active layer between the inactivated zone and the window substantially unaffected; depositing a metal to form a gate electrode through the window onto the active layer and onto the masking layer; and removing the masking layer and the metal layer thereon to expose the source and drain electrodes and leave the gate electrode on the thinner active part of the active layer above the inactivated zone.

19. A process as claimed in claim 18, wherein the inactivating ion is selected from the group consisting of $O^+$, $Cr^+$ and $B^+$.

**Patentansprüche**

1. Schottky-Gate-Feldeffekttransistor, mit einem semi-isolierenden Halbleitersubstrat, mit einer aktiven Schicht auf der Oberfläche des Halbleitersubstrats und mit einer Source-Elektrode, einer Schottky-Gate-Elektrode und einer Drain-Elektrode, welche auf der aktiven Schicht ausgebildet sind, wobei die aktive Schicht einen ersten Teil, welcher nahe der Gate-Elektrode ausgebildet ist, und einen zweiten Teil desselben Leitungstyps wie der erste Teil hat und welcher eine größere Dicke als der erste Teil hat, welcher zwischen der Gate- und der Source-Elektrode ausgebildet ist, und wobei die oberen Flächen des ersten und des zweiten Teils der aktiven Schicht in derselben Ebene liegen, dadurch gekennzeichnet, daß der zweite Teil der aktiven Schicht eine im wesentlichen gleiche Trägerkonzentration wie diejenige des ersten Teils hat.

2. Transistor nach Anspruch 1, dadurch gekennzeichnet, daß die Gate-Elektrode zumindest den ersten Teil der aktiven Schicht vollständig bedeckt.

3. Transistor nach einem der Ansprüche 1 oder 2, dadurch gekennzeichnet, daß die Source-Elektrode auf der Oberfläche des zweiten Teils der aktiven Schicht positioniert ist.

4. Transistor nach Anspruch 1, dadurch gekennzeichnet, daß die Gate-Elektrode auf dem ersten Teil der aktiven Schicht über eine Öffnung in einer Isolierschicht ausgebildet ist, wobei die Gate-Elektrode eine Länge hat, welche zumindest dieselbe wie diejenige des ersten Teils der aktiven Schicht ist, und welche in der Öffnung nur auf der Schutzschicht ausgebildet ist.

5. Transistor nach Anspruch 4, dadurch gekennzeichnet, daß die Schutzschicht aus Siliziumnitrid, Siliziumoxid, Aluminiumoxid oder Aluminiumnitrid besteht.

6. Transistor nach einem der vorherigen Ansprüche, dadurch gekennzeichnet, daß die Gate-Elektrode aus einem Metall besteht, welches bei hohen Temperaturen stabil ist und mit einer isolierenden Verbindungsschicht bedeckt ist, welche durch chemische Änderung des Metalls der Gate-Elektrode hergestellt ist.

7. Transistor nach Anspruch 6, dadurch gekennzeichnet, daß die Gate-Elektrode aus einer Ti-W-Legierung, Ta, Nb, V oder Mo besteht.

8. Transistor nach einem der vorherigen Ansprüche, dadurch gekennzeichnet, daß die Gate-Elektrode auf derselben Stelle und mit zumindest derselben Länge wie der erste Teil ausgebildet ist, und daß aktive Schichten mit demselben Leitungstyp und einer höheren Trägerkonzentration als diejenige des ersten Teils auf beiden Seiten der Gate-Elektrode und in deren Nähe sowie in der Nähe der Source- und Drain-Elektroden ausgebildet sind.

9. Verfahren zum Herstellen eines Schottky-Gate-Feldeffekttransistors, wobei auf einem semi-isolierenden Halbleitersubstrat eine aktive Schicht mit einem ersten Teil aus einem Halbleiterkristall des einen elektrischen Leitungstyps mit einer Dicke und Trägerkonzentration hergestellt wird, die so gewählt ist, daß sich eine vorherbestimmte Pinch-off-Spannung ergibt; ein streifenförmiges Photolackmuster auf der aktiven Schicht ausgebildet wird; ein Dotierungsstoff, damit sich derselbe Leitungstyp wie bei der aktiven Schicht ergibt, über die aktive Schicht durch Ionen-Implantation oder durch thermische Diffusion selektiv durch das Muster als Maske eingebracht wird, um einen zweiten tieferen Teil für die aktive Schicht auf beiden Seiten des ersten Teils auszubilden; das Muster entfernt wird und dann eine Source-Elektrode, eine Drain-Elektrode und eine Gate-Elektrode auf der sich ergebenden aktiven Bezugsschicht ausgebildet wird, dadurch gekennzeichnet, daß der Dotierstoff eingebracht wird, damit sich eine im wesentlichen gleiche Trägerkonzentration in dem zweiten Teil der aktiven Schicht wie in deren ersten Teil ergibt.

10. Verfahren nach Anspruch 9, dadurch gekennzeichnet, daß die aktive Schicht hergestellt wird, indem $^{28}Si^+$-Ionen gleichförmig in einem semi-isolierenden GaAs-Substrat eingebracht werden.

11. Verfahren nach einem der Ansprüche 9 oder 10, dadurch gekennzeichnet, daß die Pinch-off-Spannung zwischen +0,3 und −3 V liegt.

12. Verfahren nach Anspruch 9, dadurch gekennzeichnet, daß ein Muster, welches dem Photolackmuster gerade entgegengesetzt ist, durch die Abhebetechnik hergestellt wird, daß ein Dotierstoff, damit sich derselbe elektrische Leitungstyp wie bei der aktiven Schicht ergibt, über das entgegengesetzte Muster durch schräge Ionen-Implantation eingebracht wird, daß das umgekehrte Muster entfernt wird, daß ein Ausheilen für die elektrische Aktivierung des ionenimplantierten Dotierstoffs durchgeführt wird, um die Schottky-Elektrode auszubilden, und daß dann eine Source- und Drain-Elektrode hergestellt werden.

13. Verfahren nach Anspruch 12, dadurch gekennzeichnet, daß das entgegengesetzte Muster durch Aufdampfen von Al, Ta, Mo, W oder Ti im Anschluß an die Abhebetechnik hergestellt wird.

14. Verfahren nach Anspruch 9, dadurch gekennzeichnet, daß ein Muster, das dem streifenförmigen Muster gerade entgegengesetzt ist, durch die Abhebetechnik ausgebildet wird, daß ein Schottky-Gate-Metall darauf aufgedampft wird, daß eine Schottky-Gate-Elektrode ausgebildet wird, die genau auf dem ersten Teil der aktiven Schicht positioniert ist, indem die entgegengesetzte Mustermaske entfernt wird, und daß eine Source- und eine Drain-Elektrode auf dem zweiten Teil der aktiven Schicht ausgebildet wird.

15. Verfahren nach Anspruch 14, dadurch gekennzeichnet, daß das entgegengesetzte Muster durch Aufdampfen von Au im Anschluß an die Abhebetechnik ausgebildet wird.

16. Verfahren nach einem der Ansprüche 14 oder 15, dadurch gekennzeichnet, daß die Schottky-Gate-Elektrode aus Al, Ta, Mo, W oder Ti besteht.

17. Verfahren nach Anspruch 9, dadurch gekennzeichnet, daß ein Photolack zum Schaffen einer Bezugsfläche mit Hilfe von Plasmaätzen aufgebracht wird, um einen Teil des Photolacks zu entfernen und um den oberen Teil des Musters von dem Photolack her zu belichten, daß das Muster entfernt wird, indem nur der erste Teil der aktiven Schicht belichtet wird, daß ein Gate-Metall aufgedampft wird, und daß dann der Photolack entfernt wird.

18. Verfahren zum Herstellen eines Schottky-Gate-Feldeffekttransistors, dadurch gekennzeichnet, daß auf einem Halbleitersubstrat eine aktive Schicht mit einer gleichförmigen Dicke und einer planaren äußeren Fläche hergestellt wird, wobei die aktive Schicht nur einen Leitungstyp und eine im wesentlichen gleichförmige Trägerkonzentration hat, bei welchem Verfahren eine Source- und eine Drain-Elektrode auf der Oberfläche der aktiven Schicht hergestellt wird, ferner eine Maskierungsschicht über der Oberfläche der aktiven Schicht und der Source- und Drain-Elektroden hergestellt wird, wobei die Maskierungsschicht ein Fenster zwischen den Source- und Drain-Elektroden hat, bei welchem ferner ein Inaktivierungsion durch das Fenster implantiert wird, um so eine isolierende inaktivierte Zone in der aktiven Schicht und an deren Boden unter dem Fenster auszubilden, während der Teil der aktiven Schicht zwischen der inaktivierten Zone und dem Fenster im wesentlichen unbeeinflußt belassen wird, daß ein Metall aufgebracht wird, um eine Gate-Elektrode durch das Fenster in der aktiven Schicht und in der Maskierungsschicht auszubilden, und daß die Maskierungsschicht und die Metallschicht darauf entfernt wird, um die Quellen- und Drain-Elektroden zu belichten, und um die Gate-Elektrode auf dem dünneren aktiven Teil der aktiven Schicht oberhalb der inaktivierten Zone zu belassen.

19. Verfahren nach Anspruch 18, dadurch gekennzeichnet, daß das Inaktivierungsion aus der Gruppe O$^+$, Cr$^+$ und B$^+$ ausgewählt wird.

**Revendications**

1. Transistor à effet de champ à grille Schottky comportant un substrat semiconducteur semi-isolant, une couche active formée sur la surface du substrat semiconducteur, et une électrode de source, une électrode de grille à barrière de Schottky et une électrode drain formées sur la couche active, la couche active comportant une première partie formée à proximité de l'électrode de grille et une seconde partie possédant le même type de conductivité que la première partie et présentant une épaisseur supérieure à celle de la première partie qui est formée entre l'électrode de grille et l'électrode de source, les surfaces supérieures de la première partie et de la seconde partie de la couche active étant situées dans le même plan, caractérisé en ce que la seconde partie de la couche active possède une concentration en porteurs sensiblement identique à celle de la première partie.

2. Transistor selon la revendication 1, dans lequel l'électrode de grille recouvre complètement au moins la première partie de la couche active.

3. Transistor selon la revendication 1 ou 2, dans lequel l'électrode de source est positionnée sur la surface de la seconde partie de la couche active.

4. Transistor selon la revendication 1, dans lequel l'électrode de grille est formée sur la première partie de la couche active, à travers une ouverture ménagée dans une pellicule isolante, l'électrode de grille possédant une longueur au moins égale à celle de la première partie de la couche active et étant formée uniquement dans l'ouverture ménagée dans la pellicule isolante.

5. Transistor selon la revendication 4, dans lequel la pellicule isolante est constituée par du nitrure de silicium, de l'oxyde de silicium, de l'oxyde d'aluminium ou du nitrure d'aluminium.

6. Transistor selon l'une quelconque des revendications précédentes, dans lequel l'électrode de grille est constituée en un métal qui est stable aux températures élevées et est recouvert par une pellicule de composé isolant formée par modification chimique du métal constituant l'électrode de grille.

7. Transistor selon la revendication 6, dans lequel l'électrode de grille est constituée par un alliage de Ti-W, du Ta, du Nb, du V ou du Mo.

8. Transistor selon l'une quelconque des revendications précédentes, dans lequel l'électrode de grille est formée au même endroit et avec au moins la même longueur que la première partie, et des couches actives possédant le même type de conductivité et une concentration en porteurs supérieure à celle de la première partie sont formées des deux côtés de l'électrode de grille et au voisinage de cette dernière, au voisinage des électrodes de source et de drain.

9. Procédé pour fabriquer un transistor à effet de champ à grille Schottky, qui consiste à former, sur un substrat semiconducteur semi-isolant, une couche active possédant une première partie constituée par un cristal semiconducteur possédant un premier type de conductivité électrique, avec une épaisseur et une concentration en porteurs choisies de manière à fournir une tension prédéterminée de pincement, à former une structure de résist en forme de bande sur la couche active, à introduire une impureté de manière à obtenir le même type de conductivité que la couche active, à travers cette dernière, au moyen d'une implantation d'ions ou d'une diffusion thermique réalisée de façon sélective à travers la structure servant de masque, pour former une seconde partie plus profonde pour la couche active, des deux côtés de la première partie de cette couche, à éliminer la structure, puis à former une électrode de source, une électrode de drain et une électrode de grille sur la couche active mise à niveau obtenue, caractérisé en ce qu'on introduit impureté de manière à obtenir, dans la seconde partie de la couche active, une concentration en porteurs sensiblement identique à celle de la première partie de cette couche.

10. Procédé selon la revendication 9, selon lequel la couche active est formée par implantation uniforme de l'ion $^{28}$Si$^+$ dans un substrat en GaAs semi-isolant.

11. Procédé selon la revendication 9 ou 10, selon lequel la tension de pincement est comprise entre +0,3 et −3 V.

12. Procédé selon la revendication 9, consistant à former une structure directement inverse de la structure de résist, au moyen du procédé de décollement, à introduire une impureté permettant d'obtenir le même type de conductivité électrique que la couche active, à travers la structure inverse, au moyen d'une implantation ionique oblique, à éliminer la structure inverse, à réaliser un recuit pour provoquer l'activation électrique de l'impureté introduite par implantation ionique pour former l'électrode à barrière de Schottky, et à former une électrode de source et une électrode de drain.

13. Procédé selon la revendication 12, selon lequel on forme la structure inverse par un dépôt en phase vapeur de Al, Ta, Mo, W ou Ti, suivi d'un décollement.

14. Procédé selon la revendication 9, consistant à former une structure directement inverse de la structure en forme de bande au moyen du procédé de décollement, à déposer en phase vapeur sur cette structure un métal destiné à constituer la grille Schottky, à former une électrode de grille Schottky positionnée exactement sur la première partie de la couche active en éliminant le masque formé par la structure inverse, et à former une électrode de source et une électrode de drain sur la seconde partie de la couche active.

15. Procédé selon la revendication 14, selon lequel la structure inverse est formée par un dépôt en phase vapeur de Au, suivi d'un décollement.

16. Procédé selon la revendication 14 ou 15, selon lequel l'électrode de grille Schottky est constituée par du Al, Ta, Mo, W ou Ti.

17. Procédé selon la revendication 9, consistant à appliquer un photorésist en réalisant une surface mise à niveau, à mettre en oeuvre une attaque au plasma pour éliminer une partie du photorésist et à dégager la partie supérieure de la structure à partir du photorésist, à éliminer la structure de manière à exposer uniquement la première partie de la couche active, à déposer en phase vapeur un métal destiné à former la grille, puis à éliminer le photorésist.

18. Procédé pour fabriquer un transistor à effet de champ à grille Schottky, consistant à former, sur un substrat semiconducteur, une couche active possédant une épaisseur uniforme et une surface extérieure plane, cette couche active possédant un type unique de conductivité et présentant une concentration en porteurs sensiblement uniforme; à former une électrode de source et une électrode de drain sur la surface de la couche active; à former une couche de masquage sur la surface de la couche active et des électrodes de source et de drain, la couche des masquage possédant en elle une fenêtre située entre les électrodes de source et de drain; à implanter un ion d'inactivation à travers la fenêtre de manière à former une zone inactivée isolante dans la couche active et à la base de cette dernière au-dessous de la fenêtre, tout en laissant sensiblement intacte la partie de la couche active située entre la zone inactivée et la fenêtre; à déposer un métal de manière à former, à travers la fenêtre, une électrode de grille sur la couche active et sur la couche de masquage; et à éliminer la couche de masquage et la couche métallique située sur cette dernière pour mettre à nu les électrodes de source et de drain et laisser l'électrode de grille sur la partie active plus mince de la couche active au-dessus de la zone inactivée.

19. Procédé selon la revendication 18, selon lequel l'ion d'inactivation est choisi dans le groupe incluant $O^+$, $Cr^+$ et $B^+$.

# FIG. 1

# FIG. 2

# FIG. 3

# FIG. 4

(A)

(B)

(C)

FIG. 5

## FIG. 6

23    25    24

22

22"    22'

21

## FIG. 7

4    3    5

41

44    45

42    43

1

## FIG. 8

(A)

46

1

4

# FIG. 8

(B)

42   41   43

1

(C)

49

48   47   50

42   41   43

1

(D)

48   50

42   41   43

51

1

# FIG. 8

## (E)

## FIG. 9

# FIG. 10

72    70    73

63    65    64    1

# FIG. 11

(A)    61

1

(B)    62

63    65    64    1

## FIG. II

(C)

(D)

(E)

## FIG. 11

(F)

## FIG. 12

# FIG. 13

(A)

82'

81

(B)

87

82

82"  82'  82"

(C)

83  87  84

82

82"  82'  82"  81

(D)

83  87  88

84

82

82"  82'  82"  81

# FIG. 13

(E)

83    87    88
84
82
82"    82'    82"    81

(F)

83    88
84
82
82"    82'    82"    81

(G)

83    85    84
82
82"    82'    82"    81

## FIG. 14

## FIG. 15

(A)

(B)

(C)

# FIG. 15

(D)

94 — 92' 96 97 — 93 — 92 — 91

(E)

95 — 94 — 96 97 — 93 — 92 — 91

(F)

94 — 95 — 93 — 92 — 96 — 91

## FIG. 16

## FIG. 17

## FIG. 18

(A)

(B)

(C)

FIG. 18

(D)

FIG. 19

(A)

(B)

FIG. 20

(A)

## FIG. 20

(B)

(C)

(D)

## FIG. 21

(A)

## FIG. 21

(B)

(C)

## FIG. 22

## FIG. 23

(A)

## FIG. 23

(B)

125  122"

121

(C)

125  122"

122"  122"'  122'  122"'  121

(D)

123  125  124

121

## FIG. 24

133  135  134

136  137

131

132"  132'

132

# FIG. 25

(A)

132'
131

(B)

138
135
132'
131

(C)

136
138
135
137
132'
131

(D)

136
135
137
132"  132'  132"  131